# EUROPÄISCHE PATENTSCHRIFT

(11) **EP 2 830 097 B1**
(45) Veröffentlichungstag und Bekanntmachung des Hinweises auf die Patenterteilung: **24.02.2021**
(21) Anmeldenummer: 14188533.5
(22) Anmeldetag: 03.12.2009
(51) Int. Cl.: H01L 29/737, H01L 29/732, H01L 21/331, H01L 29/08, H01L 29/10, H01L 29/161, H01L 29/66

(54) **Bipolartransistor mit selbstjustiertem Emitterkontakt und Verfahren zu dessen Herstellung**
Bipolar transistor having self-adjusted emitter contact and method of manufacturing the same
Transistor bipolaire doté de contact émetteur à ajustage automatique et son procédé de fabrication

(30) Priorität: 12.12.2008 DE 102008054576; 13.03.2009 DE 102009001552
(43) Veröffentlichungstag der Anmeldung: 28.01.2015
(62) Teilanmeldung aus: 09765091.5
(73) Patentinhaber: IHP GmbH-Innovations for High Performance Microelectronics / Leibniz-Institut für innovative Mikroelektronik, 15236 Frankfurt / Oder (DE)
(72) Erfinder: Heinemann, Bernd, 15234 Frankfurt (Oder) (DE); Marschmeyer, Steffen, 15306 Lebus (DE); Fox, Alexander, 10997 Berlin (DE)
(74) Vertreter: Eisenführ Speiser

(56) Entgegenhaltungen:
- EP-A1- 0 418 421
- EP-A1- 1 517 377
- US-A- 5 286 661
- US-A- 5 516 710
- US-A1- 2001 017 399
- US-A1- 2005 023 642
- US-A1- 2008 296 623

## Beschreibung

Die Erfindung betrifft eine Bipolar-Halbleitervorrichtung mit mehreren vertikalen Bipolartransistoren, die ein Emitter-, ein Basis- und ein Kollektorgebiet aufweisen, wobei der wie üblich T-förmig ausgeführte Emitter das seitlich an die Basis anschließende Basisanschlussgebiet lateral überlappt. Weiterhin betrifft die Erfindung ein Verfahren zur Herstellung einer solchen Bipolar-Halbleitervorrichtung.

### Stand der Technik

Die Leistungsfähigkeit von Bipolartransistoren (engl.: Bipolar Junction Transistor, BJT) auf Siliziumbasis ist im Hochgeschwindigkeitsbereich durch neuartige Bauelementekonstruktionen und Materialkomponenten sowie durch Strukturverkleinerung wesentlich verbessert worden.

Wesentliche Merkmale moderner vertikaler Hochgeschwindigkeits-Bipolartransistoren sind in K. Washio, "SiGe HBT and BiCMOS Technologies", IEDM, S. 113-116, 2003 beschrieben. Weitergehende Ausführungsformen finden sich in DE 10 2004 061327 und in US 2005/006724.

Bekannte Ausführungen enthalten hoch leitfähige Basis- und Kollektoranschlussgebiete, die den Ladungsträgerstrom vom inneren Transistorgebiet zu den entsprechenden Kontaktgebieten hin abführen. Eine hohe Leitfähigkeit wird dabei durch eine lokal gut kontrollierte Dotierung und in mindestens einer Ausführung durch ein einkristallines Basisanschlussgebiet erreicht. Um gleichzeitig eine geringe Kapazität des Basisanschlussgebietes zu den übrigen elektrischen Anschlüssen des Transistors zu gewährleisten, werden die Halbleitergebiete durch Isolatorgebiete mit geringer Dielektrizitätskonstante, z. B. durch Siliziumdioxid, voneinander getrennt. Die sich ergebenden Überlappungen der Emitter- und Kollektorgebiete mit der Basis werden möglichst klein gehalten, was insbesondere durch selbstjustierte Verfahren erreicht wird.

Als Herstellungsverfahren für Bipolartransistoren (engl.: Bipolar Junction Transistor, BJT) auf Siliziumbasis im Hochgeschwindigkeitsbereich haben sich die sogenannte Doppel-Polysilizium-Technologie und die Single-Polysilizium-Technologie mit differentieller Basis-Epitaxie etabliert. Letztere wurde erweitert um technologische Ansätze zur Reduzierung des Basiswiderstandes und der Basis-Kollektor Kapazität, wie in DE 10 2004 061 327 beschrieben, sowie um technologische Ansätze zur möglichst weitgehenden Nutzung selbstjustierter Herstellungsverfahren, wie in US 2005/006724 beschrieben. Nachfolgend wird auf diese Verfahren näher eingegangen.

### a) Doppel-Polysllizlum Technologie

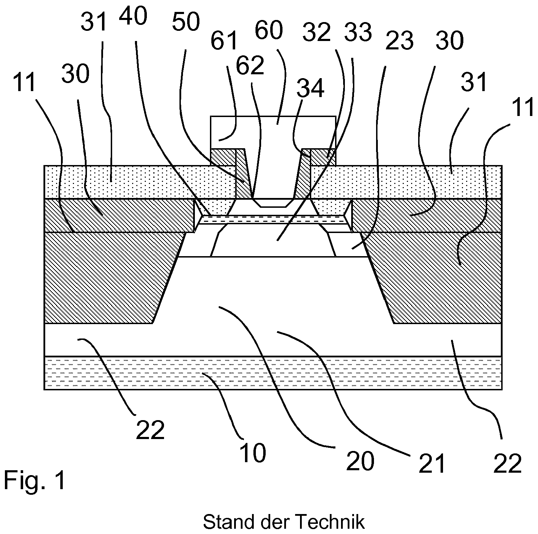

Die Zusammenhänge werden zunächst für die Doppel-Polysilizium-Technologie anhand Fig. 1 verdeutlicht. Fig. 1 zeigt in einer Querschnittsansicht einen Bipolartransistor nach dem Stand der Technik, der in seinen wesentlichen Merkmalen dem Transistor der Fig. 1(a) aus der genannten Veröffentlichung von Washio entspricht. Ein Kollektorgebiet 20 grenzt nach unten an ein Substrat 10 und seitlich (lateral) an mit Siliziumdioxid (SiO₂) ausgefüllte Vertiefungen 11 im Silizium, die auch Feldisolationsgebiete genannt werden. Dabei kommen in verschiedenen Ausführungsformen nach dem Stand der Technik entweder flache Feldisolationsgebiete in Form flacher Gräben (engl. Shallow Trench Isolation, STI), wie in Fig. 1 gezeigt, oder alternativ tiefere Gräben, so genannte Deep Trenches, zum Einsatz.

In vertikaler Richtung setzt sich das Kollektorgebiet 20 aus einem substratseitig gelegenen, hoch dotierten Kollektorbereich 21 und einem darüber liegenden, niedrig dotierten Kollektorbereich 23 zusammen. An das Kollektorgebiet schließen sich in lateraler Richtung unter den STI-Gebieten 11 Abschnitte 22 eines Kollektoranschlussgebietes an.

Über dem Kollektorgebiet 20 ist in einem Schichtstapel, der aus einer ersten Isolatorschicht 30, einer Polysiliziumschicht 31 und einer zweiten Isolatorschicht 32 besteht, ein Kollektorfenster 34 erzeugt. Durch selektive Ätzung der ersten Isolatorschicht 30 wird am seitlichen Rand des Fensters 34 ein über das erste Isolatorgebiet 30 seitlich hinausragender Abschnitt der Polysiliziumschicht 31 hergestellt. Die Stirnseiten der überhängenden Abschnitte der Polysiliziumschicht 31 sind mit Abtandshaltern, sogenannten Spacern 50 aus Isolatormaterial versehen.

Während eines selektiven Epitaxie-Schrittes zur Herstellung einer Basisschicht 40 wachsen zugleich Siliziumfronten von den freiliegenden Abschnitten der Polysiliziumschicht 31 und dem Kollektorgebiet 20 in vertikaler Richtung aufeinander zu und verschließen die Lücke zwischen der als Teil des Basisanschlussgebietes dienenden Polysiliziumschicht 31 und dem inneren Transistorgebiet.

Ein T-förmiges Emittergebiet 60 grenzt mit einem vertikalen Abschnitt, der dem vertikalen T-Balken entspricht, unten an die Basisschicht 40 und seitlich an die Spacer 50 an. Über der SiGe-Schicht ist eine Cap-Schicht abgeschieden, die im Herstellungsprozess eindiffundierende Dotanden aus dem Emitter aufnehmen kann und wenigstens einen Teil der Basis-Emitter-Raumladungszone aufnehmen kann. Die emitterseitige Grenze der Cap-Schicht ist durch eine gestrichelte Trennlinie im Emitter angedeutet. Dem horizontalen T-Balken entsprechende Abschnitte des Emitters 60 liegen seitwärts auf der zweiten Isolatorschicht 32 auf.

Ein weiteres typisches Merkmal dieser bekannten Transistorkonstruktion ist ein selektiv implantierter Kollektorbereich, auch als SIC-Bereich 33 (englisch: selectively implanted collector, SIC) bezeichnet, in welchem die Kollektordotierung lokal angehoben ist, um gleichzeitig die Kollektor-Basis-Transitzeit, die Basis-Kollektorkapazität und den Kollektorwiderstand in einer Weise zu minimieren, die gute Hochgeschwindigkeitseigenschaften des Transistors ermöglicht.

In dieser Konstruktion werden verschiedene Dimensionen selbstjustiert eingestellt. Zum einen die Überlappung der Polysiliziumschicht 31 mit der selektiv gewachsenen Basis 40, die gleichzeitig einen wichtigen Anteil an der Basis-Kollektor-Kapazität hat. Der laterale Abstand der hochdotierten Polysiliziumschicht 31 zum Emitterfenster 62 wird ebenfalls selbstjustiert durch die Spacer 50 eingestellt. Ebenso wird die Lage des SIC-Bereiches 33 selbstjustiert zum Kollektorfenster 34 und zum Emitterfenster 62 eingestellt, indem die mit Spacern 50 versehene Öffnung in der Polysiliziumschicht 31 als Maskierung dient.

### b) Single-Polysilizium Technologie

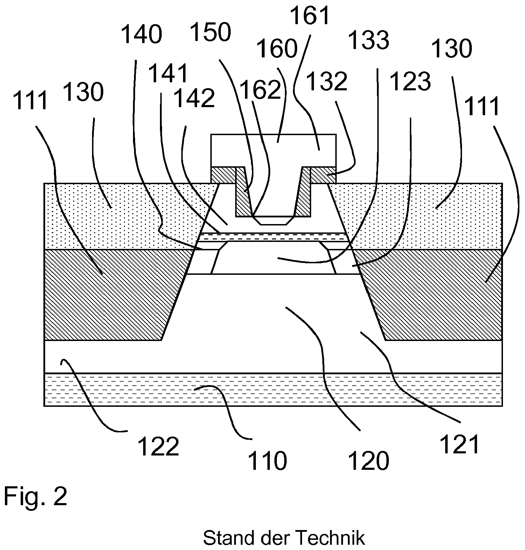

Fig. 2 zeigt in einer Querschnittsansicht einen weiteren vertikalen Bipolartransistor nach dem Stand der Technik. Schematisch dargestellt ist ein Ausschnitt des inneren Transistorgebiets sowie der angrenzendem Basis- und Kollektoranschlussgebiete. Der Transistor der Fig. 2 weist eine Einfach-Polysilizium-Konstruktion mit differentiell abgeschiedener Basis auf. Wesentliche Merkmale der Kollektorkonstruktion stimmen mit denjenigen der Doppel-Polysilizium-Variante von Fig. 1 überein.

Ein Kollektor 120 wird nach unten hin von einem Substrat 110 und zu den Seiten hin von STI-Gebieten 111 eingeschlossen. Substratseitig hat der Kollektor 120 einen hochdotierten Abschnitt 121. Zur Oberfläche hin hat der Kollektor einen niedrig dotierten Abschnitt 123. Im Unterschied zur Doppel-Polysilizium-Konstruktion der Fig. 1, bei der die Abscheidung der Polysiliziumschicht 31 unabhängig von der der Basisschicht erfolgt, wird in der Einfach-Polysilizium-Variante während des differentiellen Epitaxieschrittes für die Basisherstellung auf den Feldisolationsgebieten polykristallines Halbleitermaterial 130 deponiert, welches als Teil des Basisanschlussgebietes benutzt werden kann.

Aus den weiter oben beschriebenen Gründen wird ebenso wie in der Doppel-Polysilizium-Variante ein SIC-Gebiet 133 verwendet. Auch die bekannten Einfach-Polysilizium-Transistorkonstruktionen zeigen typischerweise schwächer dotierte Siliziumgebiete in seitlicher Nachbarschaft zum SIC-Gebiet 133, die unerwünschte Kapazitätsbeiträge zwischen Basisanschluss- und Kollektorgebiet hervorrufen.

Der Emitter wird wie in der Doppel-Polysilizium-Variante T-förmig ausgeführt, wobei die Weite der Überlappung 161 über das Emitterfenster 162 hinaus wie auch in der Doppel-Polysiliziumtechnologie photolithographisch eingestellt wird.

### c) VIEBAG-Technologie

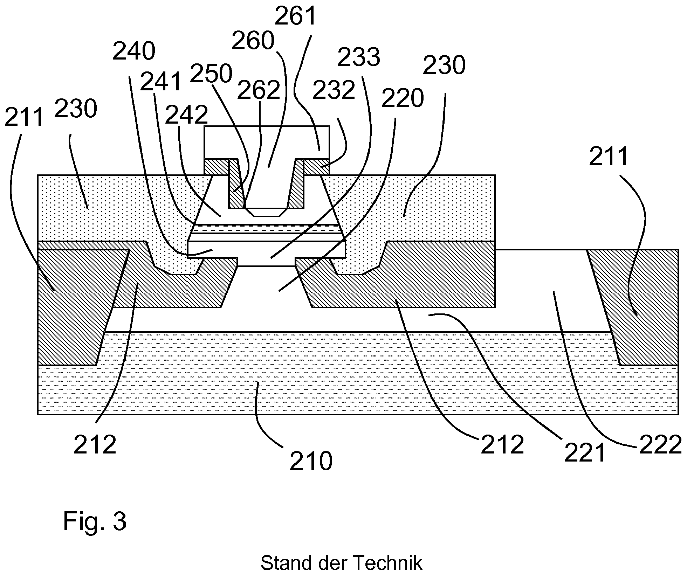

Fig. 3 zeigt in einem Querschnitt einen dritten Bipolartransistor nach dem Stand der Technik. Schematisch dargestellt ist ein Ausschnitt des inneren Transistorgebiets sowie der angrenzenden Basis- und Kollektoranschlussgebiete. Der Transistor der Fig. 3 weist eine Einfach-Polysilizium-Konstruktion mit differentiell abgeschiedener Basis auf, die gegenüber dem Transistor der Fig. 2 die Ausformung eines einkristallinen Basisanschlussgebietes erlaubt und durch die besondere Konstruktion des Kollektorbereiches eine reduzierte parasitäre Basis-Kollektor-Kapazität aufweist.

Ein Kollektor 220 wird nach unten hin von einem Substrat 210 und zu den Seiten hin von STI-Gebieten 211 eingeschlossen. Substratseitig hat der Kollektor 220 einen hochdotierten Abschnitt 221.

Der Transistor weist eine in einer Öffnung des Isolationsgebietes angeordnete erste Halbleiterelektrode aus einkristallinem Halbleitermaterial eines zweiten Leitfähigkeitstyps auf, die entweder als Kollektor oder als Emitter ausgebildet ist, und die einen ersten Höhenabschnitt besitzt, der vom Isolationsgebiet in einer zur Höhenrichtung senkrecht stehenden, lateralen Richtung umschlossen ist und einen angrenzenden, in der Höhenrichtung vom Substratinneren weiter entfernten zweiten Höhenabschnitt aufweist, der lateral nicht vom Isolationsgebiet umschlossen ist.

Weiterhin besitzt der Transistor eine zweite Halbleiterelektrode aus Halbleitermaterial des zweiten Leitfähigkeitstyps, die als der andere Typ Halbleiterelektrode, also als Emitter beziehungsweise alternativ als Kollektor ausgebildet ist, eine Basis aus einkristallinem Halbleitermaterial des ersten Leitfähigkeitstyps zwischen dem Kollektor und dem Emitter, und ein Basisanschlussgebiet, das einen einkristallinen Abschnitt aufweist, der in lateraler Richtung die Basis und den, von der Basis aus gesehen weiter zum Substratinneren liegenden, zweiten Höhenabschnitt der ersten Halbleiterelektrode lateral umgibt, und der mit seiner zum Substratinneren weisenden Unterseite unmittelbar auf dem Isolationsgebiet aufliegt, und der als vertikal isolierter einkristalliner Basisanschlussgebietsabschnitt, kurz VIEBAG-Abschnitt bezeichnet wird.

Hier ist das Emitterfenster 262 bezüglich des Basisanschlussgebietes und bezüglich des SIC selbstjustiert positioniert, während die über das Emitterfenster 262 hinausreichende Weite der Überlappung 261 des Emitters mit dem Basisanschluss 230 durch photolithographische Verfahren eingestellt wird.

### d) US 2005/006724

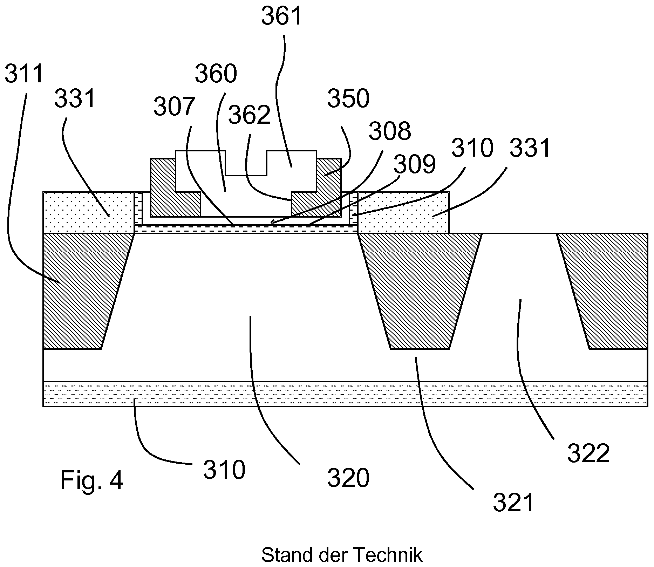

Fig. 4 zeigt in einem Querschnitt einen vierten Bipolartransistor nach dem Stand der Technik. Schematisch dargestellt ist ein Ausschnitt des inneren Transistorgebiets sowie der angrenzenden Basis- und Kollektoranschlussgebiete. Der Transistor der Fig. 4 weist eine Konstruktion mit differentiell abgeschiedener Basis auf, die sich durch eine weitgehende Nutzung selbstjustierter Verfahren auszeichnet.

Ein Kollektor 320 wird nach unten hin von einem Substrat 310 begrenzt. Im Gegensatz zu den vorabgegangenen Ausführungsformen von Transistoren nach Stand der Technik wird der Kollektor 320 über ein Verbindungsgebiet 321 unter dem Isolationsgebiet 311 hinweg zum Kollektorkontaktgebiet 322 geführt.

Der Transistor ist in einem Fenster eines Basisanschlussgebiets aus Polysilizium 331 ausgebildet, welches über dem Bereich des Kollektors 320 geöffnet ist.

Durch differentielle Epitaxie wird über dem Kollektorbereich ein einkristalliner Basisschichtstapel 307 und eine schwach dotierte Deckschicht 308 abgeschieden, währenddessen sich an den Seitenwänden des Basisanschlussgebietes eine polykristalline Verbindung 310 ausbildet.

L-förmige Spacer 350, die ebenfalls im Inneren des Fensters im Basisanschlussgebiet 331 ausgebildet sind, trennen den Emitter 360 vom Basisanschlussgebiet 331. Der gesamte Emitter ist in dieser Ausführungsform selbstjustiert zur Öffnung im Basisanschlussgebiet ausgebildet.

Die Weite des über das Emitterfenster 362 ragenden Bereiches des T-förmigen Emitters 360, der durch den unteren Teil der Spacer 350 von einem Basisanschlussgebiet 309 getrennt ist, ist zur Öffnung im Basisanschlussgebiet 331 und somit auch zum Emitterfenster 362 durch die L-förmigen Spacer 350 eingestellt.

### Zusammenfassende Kritik des Standes der Technik

Der erreichte Stand der Technik ermöglicht in der Doppel-Polysilizium Technologie nur, das Emitter- zum Kollektorfenster selbstjustiert zu positionieren. In der Single-Polysilizium Technologie ist keine derartige Selbstjustierung bekannt.

Im Ergebnis ist bisher keine von anderen wichtigen Dimensionen des Transistors unabhängige, selbstjustierte Einstellung der Weite der lateralen Überlappung des üblicherweise T-förmig ausgeführten Emitters zum seitlich an die Basis grenzenden Basisanschlussgebiet möglich.

Insbesondere ist es bisher nicht möglich, einen zum Emitterfenster selbstjustierten, seitlichen Überstand des horizontalen Balkens des T-förmigen Emitters in seiner Ausdehnung einzustellen, ohne dass zugleich der Abstand Emitterfenster-Basisanschlussgebiet verändert wird. Insbesondere hängt die Länge des Basisanschlussbereiches, die einen signifikanten Anteil am Basiswiderstand hat, unmittelbar mit der Weite des horizontalen Bereiches des T-förmigen Emitters zusammen.

Der Emitter kann zusammenfassend nicht unabhängig vom Basisanschlussbereich gestaltet und optimiert werden.

Lage und Ausdehnung des T-förmigen Emitters werden in bekannten Herstellungsverfahren darüber hinaus durch die Verwendung einer photolithographisch positionierten Maske eingestellt. Das führt dazu, dass die Dimension der Überlappung nicht ohne Berücksichtigung der mit dem photolithographischen Prozess verbundenen Fehlertoleranzen entworfen werden kann.

Eine Minimierung dieses Überlappungsgebietes wäre einerseits zur Reduzierung der parasitären Kapazität, die aus der Fläche des Überlappungsgebietes hervorgeht, erwünscht. Zum anderen könnte auf diese Weise auch der parasitäre Widerstand des Basisanschlusses verringert werden, indem bei kleinem Überlapp hoch leitfähige Gebiete des Basisanschlusses dichter an die innere Basis herangeführt werden können als es im Stand der Technik möglich ist. Solche Gebiete sind beispielsweise Silizid, eine epitaktische Verstärkung des Basisanschlusses oder eine zur Erhöhung der Dotierung verwendete zusätzliche Implantation des Basisanschlusses.

Die in den Fig. 1, 2, 3 und 4 dargestellten bekannten Transistoranordnungen zeigen überdies einen zweiten kritikwürdigen Aspekt: Die auf Isolatorgebiet liegenden Teile des Basisanschlusses bestehen in Fig. 1 , 2 und 4 aus polykristallinem Material, wodurch Kontakt- und Zuleitungswiderstände im Vergleich zu Werten für einkristallines Material spürbar vergrößert sind. In Fig. 3 ist dagegen der Basisanschluss aus einkristallinem Material gefertigt. Es wäre jedoch wünschenswert, den Widerstand des Basisanschlussgebiets weiter zu verringerr

Nachfolgend werden weitere relevante Dokumente aus dem Stand der Technik kurz beschrieben.

Das Dokument US 2005/0023642 A1 beschreibt eine Halbleitervorrichtung, die ein Substrat und ein feldisolierendes Gebiet enthält, das ein aktives Gebiet des Halbleitersubstrats begrenzt. Die Halbleitervorrichtung enthält einen Kollektor, mindestens eine Kollektorkontaktregion, die mit dem Kollektor in Verbindung steht, und eine Basis mit einer zugehörigen Basisanschlussregion. Der Kollektor und die Kollektorkontaktregion sind in dem gleichen aktiven Gebiet gebildet. Darüber hinaus erstreckt sich die Basisanschlussregion teilweise über das aktive Gebiet und ist von der Oberfläche der aktiven Region durch eine Isolatorschicht getrennt. Das Basisanschlussgebiet umfasst sowohl einen einkristallinen Teil, der auf dem Kollektor liegt, als auch einen polykristallinen Teil, der auf der Isolatorschicht liegt.

US 5,286,661 beschreibt einen bipolaren Transistor, der unter Verwendung von Niedrigtemperatur-Epitaxie zur Bildung einer Basisschicht des Transistors hergestellt wird. Der Emitter wird selbstjustiert zur Basis hergestellt, in dem eine Aushöhlung über dem Basisstapel in einer Hilfsschicht durch selektives Ätzen hergestellt wird, die dann mit Halbleitermaterial aufgefüllt wird.

Die genannten Nachteile des Standes der Technik stehen einer weiteren Verbesserung der Hochfrequenzeigenschaften eines Bipolartransistors im Weg.

Das der Erfindung zugrunde liegende technische Problem ist es daher, eine Halbleitervorrichtung für vertikale Bipolartransistoren anzugeben, bei der verbesserte Eigenschaften für Hochgeschwindigkeitsanwendungen erzielt werden, indem die beschriebenen Nachteile bekannter Ausführungen insbesondere im Hinblick auf parasitäre Kapazitäten und Widerstände verringert oder vollständig vermieden werden.

Ein weiteres, der Erfindung zugrunde liegendes technisches Problem ist es, ein Verfahren zur Herstellung einer Bipolar-Halbleitervorrichtung anzugeben, mit dem die beschriebenen Nachteile bekannter Verfahren insbesondere im Hinblick auf parasitäre Kapazitäten und Widerstände verringert oder vollständig vermieden werden können.

### Erfindungsgemäße Halbleitervorrichtung

Diese Aufgaben werden durch eine Halbleitervorrichtung gemäß Anspruch 1 gelöst.

Die erfindungsgemäße Halbleitervorrichtung zeichnet sich durch besonders gute Hochfrequenzeigenschaften ihres Bipolartransistors aus. Diese werden durch einen verringerten Widerstand des Basisanschlussgebietes erzielt, der aufgrund der erfindungsgemäßen Struktur insbesondere bei Verwendung der unten beschriebenen erfindungsgemäßen Verfahrensführung mit einer besonders geringen parasitären Basis-Emitter-Kapazität des Bipolartransistors einhergeht.

Eine geringe parasitäre Basis-Emitter-Kapazität weist der erfindungsgemäße Bipolartransistor aufgrund der weiter unten beschriebenen erfindungsgemäßen Möglichkeit einer selbstjustierten Herstellung der seitlichen Überlappung des Emitters mit dem Basisanschlussgebiet auf. Durch den Wegfall der bei sonst üblicher Einstellung durch photolithographische Verfahren zu berücksichtigenden Fehlertoleranzen kann das Überlappungsgebiet kleiner gemacht werden. Durch die geringere Überlappung des Querbalkens des T-förmigen Emitters können hochleitfähige Abschnitte des Basisanschlussgebietes besonders nahe an den inneren Transistor herangebracht werden. Diese hochleitfähigen Abschnitte können beispielsweise silizierte Gebiete, epitaktische Verstärkungen des Basisanschlussgebietes oder durch Implantation höher dotierte Gebiete sein.

Dieser Vorteil kann grundsätzlich auch erzielt werden, wenn das Basisanschlussgebiet aus dem gleichen Material hergestellt wird wie die funktionalen Schichten des inneren Transistors.

Nachfolgend werden Ausführungsbeispiele der erfindungsgemäßen Halbleitervorrichtung beschrieben. Wie sich auch aus den Rückbezügen der beigefügten Ansprüche ergibt, können die zusätzlichen Merkmale der Ausführungsbeispiele mit einander kombiniert werden, um weitere Ausführungsbeispiele zu bilden, soweit diese zusätzlichen Merkmale nicht als Alternativen zueinander offenbart sind

Das Material des Basisanschlussgebiets ist vorzugsweise Siliziumgermanium mit einem Germaniumanteil von mehr als 35%, also Si₁₋ₓGeₓ, wobei x mindestens 0,35 beträgt. Siliziumgermanium mit einem derart hohen Germaniumanteil zeichnet sich durch eine gegenüber Silizium deutlich höhere Löcherbeweglichkeit aus. Auf diese Weise kann mit Materialien, die mit bekannten industriellen Herstellungsprozessen kompatibel sind, ein besonders geringer Widerstand im Basisanschlussgebiet erzielt werden. Ein noch stärkerer Effekt in dieser Richtung kann bei Verwendung von Siliziumgermanium mit einem Germaniumanteil von mehr als 50% oder, noch weiter verbessert, sogar mehr als 80% für das Basisanschlussgebiet erzielt werden.

In einem Ausführungsbeispiel ist das Material des Basisanschlussgebiets Germanium ("x=1"), während das Material von Kollektor, Basis und Emitter Silizium oder Siliziumgermanium ist. Germanium weist im Vergleich mit Silizium eine sogar um einen Faktor von etwa 10 erhöhte Löcherbeweglichkeit auf. Auch gegenüber den gängigen Varianten von Siliziumgermanium, die einen relativ geringen Germaniumanteil aufweisen, hat Germanium eine deutlich erhöhte Löcherleitfähigkeit.

Es versteht sich, dass sich der Vergleich der Löcherleitfähigkeiten unterschiedlicher Materialien auf wenigstens in etwa gleiche Dotierstoffkonzentrationen bezieht und hierfür lediglich solche Dotierstoff-Konzentrationswerte in Betracht kommen, die in einem für die Transistorfertigung interessanten Wertebereich liegen.

Die Verwendung von einkristallinem Halbleitermaterial im Basisanschlussgebiet schafft erfindungsgemäß einen zusätzlichen Vorteil gegenüber den bekannten Varianten des Standes der Technik. Das Basisanschlussgebiet ist, abgesehen von einer Ankeimschicht oder einer Metallisierungsschicht, in unterschiedlichen Ausführungsbeispielen der Halbleitervorrichtung ganz oder teilweise einkristallin. Beispielsweise kann das Basisanschlussgebiet zwei Teilgebiete enthalten, von denen nur ein unmittelbar an die Basis angrenzendes erstes Teilgebiet einkristallin ist, ein zweites jedoch polykristallin.

Ein zumindest teilweise einkristallines Basisanschlussgebiet sorgt im Vergleich mit polykristallinem Material für eine verbesserte Leitfähigkeit. Als einkristallin werden hier Abschnitte bezeichnet, die eine einheitliche kristallographische Orientierung besitzen, die entweder durch das Substrat vorgegeben ist oder einer der anderen hochsymmetrischen Oberflächenorientierungen, im Falle des Siliziums den Oberflächenorientierungen (100), (110), (111) oder (311) entspricht. Im Gegensatz dazu werden als polykristalline Gebiete solche Gebiete bezeichnet, die aus einer Mehrzahl von Kristalliten mit verschiedenen kristallographischen Orientierungen bestehen, die in Korngrenzen aneinander grenzen und Ausdehnungen von einigen Nanometern bis zu einigen hundert Nanometern besitzen können.

Zur weiteren Verringerung des Basiswiderstandes trägt die Möglichkeit bei, die Schichtdicke des Basisanschlusses in einem gewissen Abstand von der inneren Basis zu vergrößern.

Bevorzugt ist zwischen dem Kollektor und der Basis eine Pufferschicht aus einkristallinem Halbleitermaterial angeordnet.

Zwischen der Basis und dem Emitter kann eine Deckelschicht aus einkristallinem Halbleitermaterial angeordnet sein.

Betrachtet man eine erfindungsgemäße Halbleitervorrichtung mit einer Vielzahl vertikaler Bipolartransistoren, wie sie erfindungsgemäß aufgebaut sind, so wird erreicht, dass der horizontale T-Balken des T-förmigen Emitters, der nach außen hin mit dem jeweiligen Basisanschlussgebiet überlappt, über die Gesamtzahl dieser Bipolartransistoren der Halbleitervorrichtung betrachtet, eine Überlappung mit einer Variation ihrer lateralen Ausdehnung von maximal 10 Nanometer aufweist. Eine derart homogene Struktur in Bezug auf die Überlappung kann durch die erfindungsgemäße Verfahrensführung erzielt werden, die nachfolgend erläutert wird.

Gemäß einem zweiten Aspekt der vorliegenden Erfindung wird ein Verfahren zur Herstellung eines vertikalen Bipolartransistors gemäß Anspruch 6 angegeben

Mit dem erfindungsgemäßen Verfahren wird eine selbstjustierte Einstellung der Überlappungsweite des horizontalen T-Balkens des Emitters mit dem Basisanschlussgebiet erreicht. Selbstjustiert bedeutet in diesem Zusammenhang, dass die laterale Positionierung oder Strukturausdehnung eines Gebietes bezüglich bereits hergestellter Gebiete nicht über die Justage einer photolithographischen Maske erfolgt, sondern die bereits hergestellten Gebiete selbst die Positionierung vorgeben und, eventuell mit Abstandshaltern versehen, als Maskierung für Prozessschritte dienen. Dadurch werden Lagefehler eliminiert und Dimensionen wie Abstände von Gebieten zueinander durch gut kontrollierbare Prozesse wie Schichtabscheidungen definiert, was insgesamt eine deutliche Verkleinerung von Abständen und Dimensionen im Vergleich zu über Photolithographie zueinander positionierten Gebieten erlaubt. Die bei den bisher genutzten lithographischen Verfahren vorhandenen Fehlertoleranzen bei der Dimensionierung der Überlappung müssen beim erfindungsgemäßen vertikalen Bipolartransistor nicht berücksichtigt werden, was die oben bereits beschriebenen Vorteile einer besonders geringen parasitären Basis-Emitter-Kapazität, die die Hochfrequenz-Eigenschaften des Transistors verbessert.

Das erfindungsgemäße Verfahren kann in einem Ausführungsbeispiel insbesondere so ausgeführt werden, dass das Basisanschlussgebiet, abgesehen (gegebenenfalls) von einer zum Substrat hin angrenzenden Ankeimschicht oder einer zu einem Basiskontakt hin angrenzenden Metallisierungsschicht, aus einem Halbleitermaterial hergestellt wird, das vom Halbleitermaterial des Kollektors, der Basis und des Emitters in seiner chemischen Zusammensetzung verschieden ist und im Vergleich mit diesem eine höhere Beweglichkeit von Majoritätsladungsträgern des ersten Leitfähigkeitstyps aufweist. Die Vorteile dieser Verfahrensführung wurden oben im Zusammenhang mit Ausführungsformen der erfindungsgemäßen Halbleitervorrichtung bereits erläutert. Eine Ankeimschicht kann dazu verwendet werden, in an sich bekannter die kristallinen Eigenschaften des Basisanschlussgebiets, insbesondere bei Herstellung eines einkristallinen Basisanschlussgebiets zu verbessern. Es ist jedoch nicht zwingend erforderlich. Eine Metallisierungsschicht kann auch ohne vorherige Bedeckung des Basisanschlussgebiets mit einer zusätzlichen Halbleiterschicht hergestellt werden, wie etwa Silizium zur Herstellung einer Metallisierungsschicht aus Titansilizid oder Kobaltsilizid. Für Germanium gelingt beispielsweise die Herstellung einer Nickelsilizidschicht ohne vorherige Abscheidung einer Siliziumschicht vor Bildung des Silizids. Es kann aber für bestimmte Anwendungen, die den Vorteil der Metallisierungsschicht nicht nutzen, auf die Herstellung der Metallisierungsschicht verzichtet werden.

Die Verfahrensführung geht vorteilhafterweise das Abscheiden des Schichtstapels von einem hochohmigen einkristallinen Halbleitersubstrat des ersten Leitfähigkeitstyps aus an, das in vorherigen Prozessschritten mit dem ersten Höhenabschnitt eines Kollektorgebiets des zweiten Leitungstyps, der lateral von einem ersten Isolationsgebiet begrenzt wird, versehen worden ist.

Für die daran anschließende Verfahrensführung bieten sich zwei alternative Varianten an.

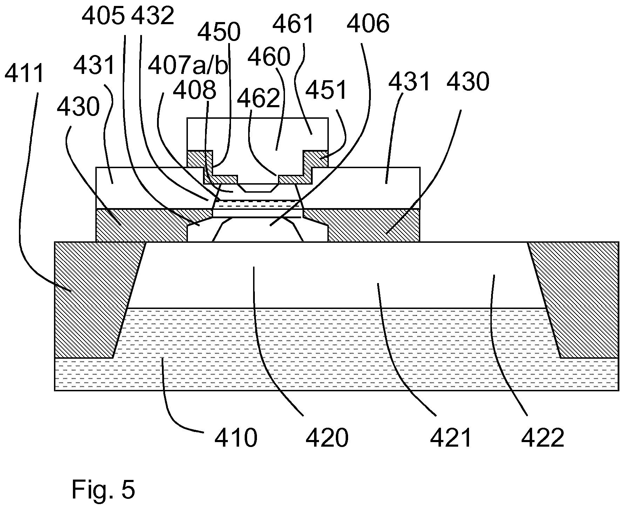

In einer ersten Variante wird der Schichtstapel, in Richtung des Schichtwachstums, entweder die folgende Schichtkombination enthaltend oder aus der folgenden Schichtkombination bestehend hergestellt: ein zweites Isolationsgebiet, eine polykristalline oder amorphe Halbleiterschicht, eine Isolationsschicht, eine erste Hilfsschicht und eine zweite Hilfsschicht. Eine Detailbeschreibung eines Ausführungsbeispiels, das auf dieser ersten Variante beruht, wird unten anhand der Figuren 5 bis 12 näher beschrieber Die erste Variante ist allerdings nicht Teil der beanspruchten Erfindung.

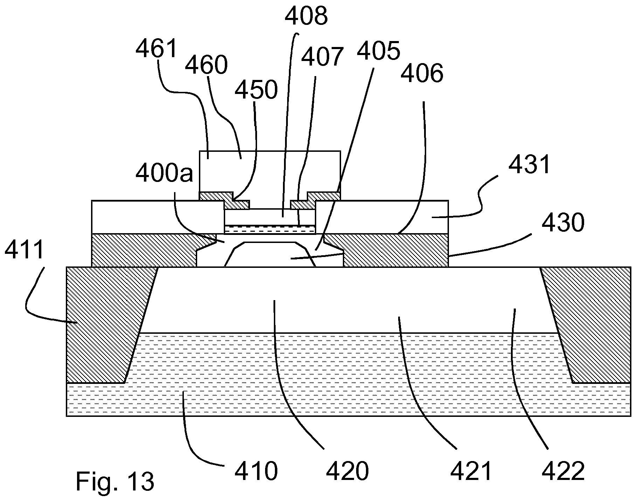

In einer zweiten Variante wird der Schichtstapel, in Richtung des Schichtwachstums, entweder die folgende Schichtkombination enthaltend oder aus der folgenden Schichtkombination bestehend hergestellt: ein zweites Isolationsgebiet, eine erste Hilfsschicht, eine zweite Hilfsschicht und eine dritte Hilfsschicht. Eine Detailbeschreibung eines Ausführungsbeispiels, das auf dieser zweiten Variante beruht, wird unten anhand der Figuren 13 bis 21 näher beschrieben.

Nachfolgend werden zunächst Ausführungsformen der ersten Variante erläutert.

Das Ausbilden des Fensters wird im Schichtstapel vorzugsweise so durchgeführt, dass sich das Fenster im lateralen Bereich des Kollektors von der zweiten Hilfsschicht in Tiefenrichtung bis zur Grenzfläche zwischen der Halbleiterschicht und dem zweiten Isolationsgebiet erstreckt. Dies ermöglicht einen anschließenden Zugriff auf das zweite Isolationsgebiet zur Herstellung des zweiten Höhenabschnitts des Kollektors Basisstapels im inneren Transistorgebiet.

Vor der Öffnung des zweiten Isolationsgebiets im Bereich des Fensters zur Erzeugung des zweiten Höhenabschnitts des Kollektors erfolgt jedoch vorteilhafterweise zunächst eine Erzeugung von Spacern an den Innenwänden des Fensters. Mit den Spacern kann die laterale Ausdehnung eines vorzugsweise in einem nachfolgenden Implantationsschritt gebildeten SIC-Gebiets im oberen Höhenabschnitt des Kollektors eingestellt werden. Außerdem verhindern sie ein laterales "Zuwachsen" des Fensters, insbesondere im Bereich der Halbleiterschicht des Schichtstapels. Die Implantation des SIC-Gebiets kann grundsätzlich vor oder nach Abscheidung eines Basisstapels im Fenster erfolgen.

Die Spacer sind jedoch auch für die weitere Verfahrensführung hilfreich. Daher folgt vorzugsweise im weiteren Verlauf nur ein teilweises Entfernen der Spacer von der Seitenwand der Halbleiterschicht, die das Basisanschlussgebiet bilden wird, gefolgt von einem selektives epitaktischen Abscheiden des Basisstapels im Bereich des Fensters. Der Basisstapel besteht in einer Ausführungsform aus einer Pufferschicht, einer Basisschicht sowie einer Deckschicht. Die Abscheidung erfolgt nun vorzugsweise gezielt in der Art, dass gleichzeitig an der Seitenwand der Halbleiterschicht ein polykristalliner innerer Bereich des Basisanschlussgebietes entsteht. Dies kann beispielsweise erreicht werden, indem die Spacer beim teilweisen Entfernen auch von unten her angegriffen werden, so dass sie im Bereich der Halbleiterschicht abschnittsweise vollständig entfernt werden.

Bei der vorliegenden ersten Variante kann das Herstellen der Aushöhlung in einer Ausführungsform durch seitliches, selektives Zurückätzen der ersten Hilfsschicht im Bereich des Fensters erreicht werden, so dass eine sich seitlich über das Fenster hinaus erstreckende seitliche Aushöhlung der ersten Hilfsschicht entsteht. Das Abscheiden des T-förmigen Emitters im Fenster und in der Aushöhlung der ersten Hilfsschicht erfolgt daher anschließend in selbstjustierter Weise, wobei sich insbesondere die Weite der über die laterale Ausdehnung des Fensters hinausragenden lateralen Überlappung des Emitters mit dem Basisanschlussgebiet durch die Weite der Zurückätzung der ersten Hilfsschicht in erfindungsgemäß selbstjustierter Weise ergibt.

Nachfolgend werden Ausführungsformen der zweiten Variante beschrieben.

Das Ausbilden des Fensters im Schichtstapel wird auch hier vorzugsweise so durchgeführt, dass sich das Fenster sich im lateralen Bereich des Kollektorgebiets in Tiefenrichtung bis zu dessen erstem Höhenabschnitt erstreckt. Anschließend wird vorzugsweise ein selektiv epitaktisches Abscheiden eines zweiten Höhenabschnitts des Kollektors im Bereich des Fensters und eines Basisstapels. Der Basisstapel besteht in einer Ausführungsform in Wachstumsrichtung aus einer Pufferschicht, einer Basisschicht sowie einer Deckschicht. Das Wachstum des Schichtstapels erfolgt vorzugsweise so weit, dass der Basisschichtstapel in Wachstumsrichtung maximal bis zur Unterseite der zweiten Hilfsschicht reicht.

Bei dieser zweiten Variante wird vorzugsweise anschließend ein selektives, seitliches Zurückätzen der zweiten Hilfsschicht im Bereich des Fensters durchgeführt, so dass eine sich seitlich über das Fenster hinaus erstreckende seitliche Aushöhlung der zweiten Hilfsschicht entsteht.

So kann das Abscheiden des T-förmigen Emitters im Fenster und in der Aushöhlung der zweiten Hilfsschicht in selbstjustierter Weise nachfolgen, wobei sich wiederum insbesondere die Weite der über die laterale Ausdehnung des Fenster hinausragenden lateralen Überlappung des Emitters mit dem Basisanschlussgebiet durch die Weite der Zurückätzung in selbstjustierter Weise ergibt.

Die Verfahrensführung der zweiten Variante wird vorteilhafter Weise anschließend mit den folgenden Schritten fortgesetzt:
- Entfernen der dritten Hilfsschicht und Abdecken des Emitters mit einer vierten Hilfsschicht,
- Strukturierung der zweiten und vierten Hilfsschicht, so dass sie nur noch im Gebiet des gewünschten Basisanschlussgebietes vorhanden sind,
- Zurückätzen der ersten Hilfsschicht unterhalb der zweiten Hilfsschicht, so weit, dass die Seitenwand der Basis freiliegt, und
- Erzeugen des Basisanschlussgebietes durch selektives epitaktisches Wachstum.

Hierbei wird in einer Ausführungsform zunächst nur ein Teil des Basisanschlussgebietes selektiv epitaktisch gewachsen und danach der vertikale Abstand der Isolationsschicht und der zweiten Hilfsschicht durch isotropes Ätzen vergrößert, so dass dann der übrige Teil des Basisanschlussgebietes durch selektive oder differentielle Epitaxie erzeugt wird. Auf diese Weise kann nach außen hin eine höhere Schichtdicke des Basisanschlussgebiets als im inneren Bereich erzielt werden, wodurch der Widerstand des Basisanschlussgebiets verringert werden kann.

Weitere Merkmale und Vorteile der Erfindung ergeben sich aus der nachfolgenden Beschreibung von Ausführungsbeispielen anhand der Figuren. Es zeigen:
Fig. 1 zeigt eine Querschnittsansicht eines vertikalen Bipolartransistors, gefertigt in Doppel-Polysilizium-Technologie, nach dem Stand der Technik.
Fig. 2 zeigt den Querschnitt eines vertikalen Bipolartransistors, gefertigt in Single-Polysilizium-Technologie, nach dem Stand der Technik.
Fig. 3 zeigt eine Querschnittsansicht eines vertikalen Bipolartransistors nach dem Stand der Technik gefertigt in VIEBAG-Technologie.
Fig. 4 zeigt eine Querschnittsansicht eines vertikalen Bipolartransistors nach dem Stand der Technik gemäß US 2005 006724
Fig. 5 zeigt eine Querschnittsansicht eines Ausführungsbeispiels eines nicht erfindungsgemäßen vertikalen Bipolartransistors.
Fig. 6 bis 12 zeigen Querschnittsansichten des vertikalen Bipolartransistors der Fig. 5 in unterschiedlichen Stadien eines nicht erfindungsgemäßen Ausführungsbeispiels für ein Verfahren zu seiner Herstellung.
Fig. 13 zeigt eine Querschnittsansicht eines Ausführungsbeispiels eines erfindungsgemäßen vertikalen Bipolartransistors.
Fig. 14 bis 20 zeigen Querschnittsansichten des vertikalen Bipolartransistors der Fig. 13 in unterschiedlichen Stadien eines Ausführungsbeispiels für ein Verfahren zu seiner Herstellung.
Fig. 21 zeigt eine Querschnittsansicht einer alternativen Ausführung des Ausführungsbeispiels eines erfindungsgemäßen vertikalen Bipolartransistors.

### Beispiel 1:

Zunächst wird nachfolgend mit Bezug auf die Figuren 5 bis 12 ein Ausführungsbeispiel beschrieben, das nicht Gegenstand der vorliegend beanspruchten Erfindung ist. Ein erstes Ausführungsbeispiel einer Halbleitervorrichtung mit einem vertikalen Bipolartransistor, bei dem die Überlappung von Emitterkontakt und Basisanschlussgebiet in selbstjustierter Weise bezüglich des Emitterfensters hergestellt ist, wird nun unter Bezugnahme auf Fig. 5 erläutert. Fig. 5 zeigt eine Querschnittsansicht dieses ersten Ausführungsbeispiels,

In diesem Beispiel ist ein vertikaler npn-Bipolartransistor auf einem hochohmigen, einkristallinen p⁻-leitfähigen Si-Substrat 410 gefertigt. Die hier beschriebene Anordnung ist jedoch nicht auf p-leitfähige Si-Substrate beschränkt. Die wesentlichen Merkmale können auch auf Substrate vom entgegengesetzten Leitfähigkeitstyp übertragen werden. Außerdem können gleichzeitig CMOS-Transistoren auf dem Substrat 410 vorhanden sein, sind aber in Figur 5 nicht dargestellt.

Der vertikale npn-Bipolartransistor der Fig. 5 umfasst einen n-leitenden unteren Kollektorbereich 420, der einen ersten Höhenabschnitt eines Kollektors des Bipolartransistors bildet, und einen ebenfalls n-leitenden Emitter 460. Der Kollektor ist seitlich über ein Kollektoranschlussgebiet 421 mit einem Kollektorkontaktgebiet 422 verbunden. Kontaktstrukturen wie Emitter-Basis- und Kollektorkontakt sind in Fig. 5 der Einfachheit der Darstellung halber graphisch nicht ausgeführt.

Zwischen Emitter 460 und dem unteren Kollektorbereich 420 ist ein einkristalliner Schichtstapel angeordnet, der einen oberen Kollektorbereich 405 als einen zweiten Höhenabschnitt des Kollektors, einen Basisschichtstapel 407, bestehend aus einer Pufferschicht 407a und der Basisschicht 407b, und eine Deckschicht 408 enthält.

Der zweite Höhenabschnitt des Kollektors 405 ist durch selektives epitaktisches Wachstum auf dem Kollektor 420 in dem Bereich eines Fensters in der Isolationsschicht 430 entstanden und kann eine Dicke von 5 nm bis 200 nm, vorzugsweise 60 nm bis 150 nm besitzen. In einem inneren Bereich 406 ist der zweite Höhenabschnitt 405 n-dotiert. Außerhalb des inneren Bereichs 406 ist der zweite Höhenabschnitt 405 schwach n- oder schwach p-dotiert. Die n-Dotierung im inneren Bereich 406 ist durch Ionenimplantation hergestellt. Der innere Bereich wird auch als SIC-Bereich bezeichnet.

Der Basisschichtstapel 407 enthält zunächst eine Pufferschicht 407a. Diese Schicht kann 5 nm bis 120 nm, vorzugsweise 30 nm bis 70 nm dick sein. Oberhalb der Pufferschicht ist die p-dotierte Basisschicht 407b erzeugt. Die Dicke der Basisschicht kann 5 nm bis 100 nm, vorzugsweise 10 nm bis 50 nm betragen. Über dem Basisschichtstapel liegt eine 5 nm bis 100 nm, vorzugsweise 10 nm bis 50 nm dicke Deckschicht 408, die ebenfalls durch selektives epitaktisches Wachstum hergestellt wird.

Die Basis 407 kann vorzugsweise in eine Legierung von SiGe eingebracht werden. Außerdem kann in der Pufferschicht 407a, in der Basisschicht 407b oder in der Cap-Schicht 408 Kohlenstoff während der Epitaxie eingebaut worden sein.

Seitlich schließt sich an die Schichten 407 und 408 nach außen hin eine polykristalline Schicht mit den Basisanschlussgebieten 432 und 431 an. Das innere Basisanschlussgebiet 432 entsteht während des epitaktischen Wachstums der Schichten 407 und 408 und besitzt eine laterale Ausdehnung von 5nm bis 150nm und eine vertikale Ausdehnung von 5 nm bis 150 nm. Das äußere Basisanschlussgebiet 431 besitzt eine Dicke von 20 nm bis 200 nm, vorzugsweise 50 nm bis 150 nm.

Eine erste Art Isolationsgebiete 411, im Weiteren als Feldisolationsgebiete bezeichnet, ragt ins Substratinnere hinein und begrenzt den unteren Kollektorbereich 420 seitlich. Als Feldisolationsgebiete können sogenannte "Shallow-Trench" Isolationen, wie sie aus CMOS-Technologien bekannt sind, eingesetzt werden. Dabei handelt es sich um vorzugsweise 250 bis 600 nm tiefe Gräben, die z. B. mit Siliziumdioxid (SiO₂), aber auch mit einer Kombination aus Isolatormaterial und Polysilizium verfüllt sein können. Alternativ können auch mittels lokaler Oxidation (LOCOS) hergestellte Feldisolationsgebiete eingesetzt werden. Zusätzlich zu den flachen Feldisolationsgebieten sind auch tiefe, z. B. mit SiO₂ verfüllte Gräben, sogenannte "Deep-Trenches", nutzbar, die jedoch in der Anordnung gemäß Fig. 5 nicht vorgesehen sind.

Die erste Isolationsschicht 430 ist 20 nm bis 200 nm dick und liegt teilweise auf dem Isolationsgebiet 411 und teilweise auf dem Kollektor 420 auf. Die Isolationsschicht besteht vorzugsweise aus einem Isolatormaterial mit kleiner Dielektrizitätskonstante. Dafür kann Siliziumdioxid (SiO₂), aber auch ein anderes, sogenanntes low-k Material verwendet werden.

Oberhalb des Schichtstapels aus erster Isolationsschicht 430, und Basisanschlussgebiet 431 befindet sich eine zweite strukturierte Isolationsschicht 451. Diese kann vorzugsweise aus einer 10 nm bis 150 nm, vorzugsweise 30 nm bis 120 nm dicken SiO₂-Schicht bestehen. Sie kann aber auch aus einer Kombination verschiedener Isolatormaterialien zusammengesetzt sein.

Ein aus Isolationsmaterial bestehender, in etwa L-förmiger Spacer 450 sichert die elektrische Isolation des Emitters 460 vom Basisanschlussgebiet 431 und 432. Das genaue Profil des Spacers ist nicht exakt L-förmig, wie sich aus den Figuren entnehmen lässt. Der Spacer könnte etwas genauer auch als Z-förmig oder Doppel-L-förmig beschrieben werden, wird jedoch der in der Fachwelt gepflegten Gewöhnung folgend hier als L-förmig bezeichnet, ohne damit eine Festlegung auf die exakte L-Form zu treffen.

Die von den Spacern 450 gebildete Öffnung über der Deckschicht 408 definiert das Emitterfenster 462. Eine hoch dotierte Siliziumschicht vom Leitungstyp des Kollektors, die npn-Emitterschicht 460, bedeckt das Emitterfenster, die Spacer 450 sowie die Isolatorschicht 451. Die npn-Emitterschicht 460 kann als polykristallines, amorphes, partiell einkristallines, partiell polykristallines oder als einkristallines Material abgeschieden werden und ist im endgültigen Zustand polykristallin, einkristallin oder in Teilbereichen einkristallin bzw. polykristallin. Aus der hoch dotierten npn-Emitterschicht 460 kann während eines Hochtemperaturschrittes n-Dotierstoff in die Cap-Schicht 408 durch das Emitterfenster eindiffundiert sein, was durch eine bogenförmige Linie in der Deckschicht 408 direkt unterhalb des Emitters angedeutet ist. Der Emitter umfasst in diesem Fall die npn-Emitterschicht 460 sowie das eindiffundierte n-Gebiet.

In einem folgenden Silizierungsschritt entstehen im Vergleich zu hochdotiertem Si noch besser leitfähige Silizidschichten, Die Oberfläche der Transistor- und Isolationsgebiete wird schließlich mit einer Isolatorschicht oder -schichtkombination abgedeckt. Mit leitfähigem Material verfüllte Kontaktlöcher und darüber liegende Metallstreifen stellen den elektrischen Anschluss zu den Kontaktgebieten des Transistors her.

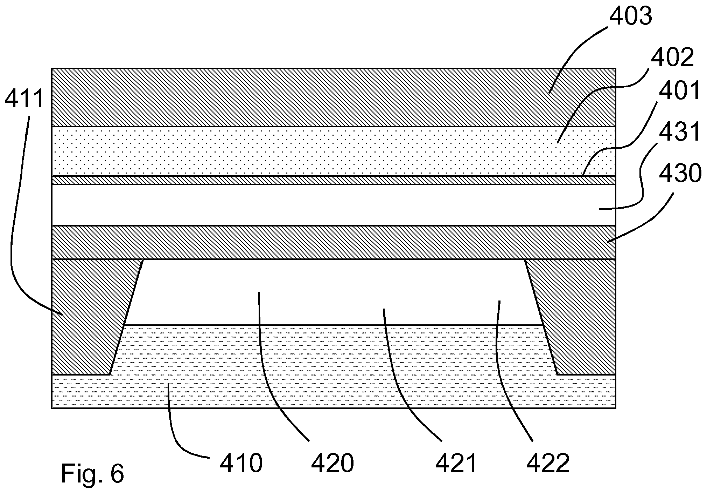

Es wird nun mit Bezug auf die Figuren 6 bis 12 ein Verfahren zur Herstellung der nicht erfindungsgemäßen Halbleitervorrichtung wie oben in diesem Beispiel beschrieben erläutert.

Grundlage für die Herstellung bildet ein Substrat 410 (Fig.6), das vorzugsweise ein möglichst hochohmiges, einkristallines p-leitendes (geringe p-leitende Dotierung) Silizium umfasst. Der Bearbeitungsprozess des Substrates 410 beginnt mit der Erzeugung der Feldisolationsgebiete 411. Im vorliegenden Beispiel werden als Feldisolationsgebiete sogenannte "Shallow Trenches" eingesetzt. Zwischen den Feldisolationsgebieten entstandene Inseln von Si-Gebieten bilden aktive Gebiete. Das aktive Gebiet wird nach Fertigstellung des vertikalen Bipolartransistors den Kollektorbereich 420, das Kollektoranschlussgebiet 421 und Kollektorkontaktgebiet 422 aufnehmen.

Die Dotierung des Kollektorbereiches 420 wird nach Fertigstellung der Feldisolationsgebiete durch Ionenimplantation in das Silizium eingebracht.

Fig. 6 zeigt eine Momentaufnahme während der Fertigung des Bipolartransistors. Feldisolationsgebiete 411 und Kollektorbereich 420 sind bereits hergestellt. Des Weiteren ist ein Schichtstapel, in diesem Ausführungsbeispiel bestehend aus einer Isolationsschicht 430, die ein zweites Isolationsgebiet bildet, einer Halbleiterschicht 431, einer weiteren Isolationsschicht 401, einer ersten Hilfsschicht 402 und einer zweiten Hilfsschicht 403 erzeugt worden, der den gesamten Wafer bedeckt. Die Isolationsschicht 401 besteht dabei vorzugsweise aus SiO₂ und ist 20 nm bis 200 nm, vorzugsweise 80 nm bis 120 nm dick. Die Halbleiterschicht 431 besteht vorzugsweise aus polykristallinem, p-dotiertem Silizium und ist 20 nm bis 200 nm, vorzugsweise 80 nm bis 120 nm dick. Die Isolationsschicht 401 besteht vorzugsweise aus SiO₂ und ist 10 nm bis 100 nm, vorzugsweise 30 nm bis 70 nm dick. Die erste Hilfsschicht 402 besteht vorzugsweise aus Si₃N₄ und ist 100 nm bis 200 nm, vorzugsweise 130 nm bis 170 nm dick. Die zweite Hilfsschicht 403 besteht vorzugsweise aus SiO₂ und ist 150 bis 250, vorzugsweise 170 nm bis 210 nm dick. Bei allen Schichtdicken ist zu beachten, dass sie nicht unabhängig voneinander oder von sonstigen Prozessparameter, besonders denen von Ätzprozessen, gewählt werden können.

Auf die zweite Hilfsschicht 403 kann in einer Ausführungsvariante zugunsten einer höheren Schichtdicke der ersten Hilfsschicht 402 verzichtet werden. Die anfängliche Schichtdicke der ersten Hilfsschicht sollte dann die Abtragungsrate der ersten Hilfsschicht in einem unten beschriebenen Ätzprozess zur Ausbildung eines Fensters 400 und in einem Ätzprozess zur Bildung einer seitlichen Aushöhlung in der ersten Hilfsschicht im Bereich des Fensters berücksichtigen. Für die nachfolgende Beschreibung wird jedoch von einer vorhandenen zweiten Hilfsschicht 403 ausgegangen.

Durch einen üblichen photolithographischen Prozess strukturiert und mit Hilfe von üblichen anisotropen Trockenätzprozessen wird ein Fenster, im Folgenden Transistorfenster genannt, in den Schichten 403, 402, 401 und 431 erzeugt. Der letzte Trockenätzprozess ist idealerweise so gestaltet, dass die Ätzung die Schicht 431 selektiv zu SiO₂ ätzt und die Ätzung somit auf der Isolationsschicht 430 stoppt.

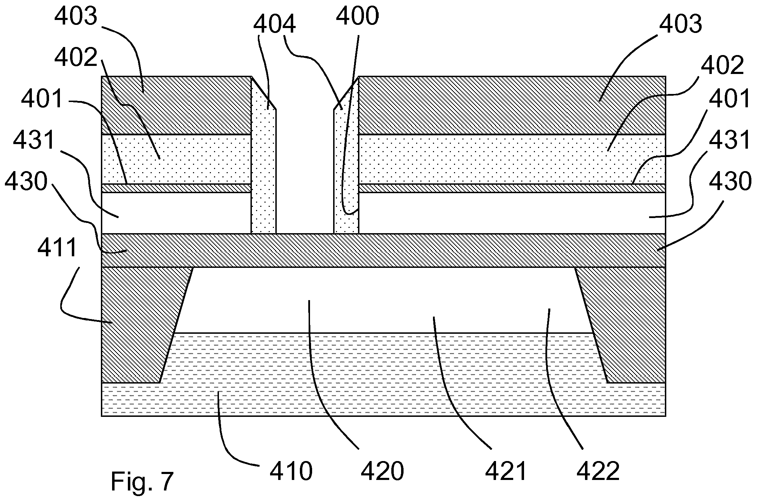

Im Inneren des Transistorfensters werden nun Spacer 404, vorzugsweise aus Si₃N₄ bestehend, durch Schichtabscheidung und nachfolgende anisotrope Trockenätzung erzeugt. Der Moment unmittelbar nach der Erzeugung der Spacer ist in Fig. 7 gezeigt. Die Breite der Spacer beträgt 50 nm bis 130 nm, vorzugsweise 70 nm bis 110 nm.

Nun wird im Bereich des Transistorfensters auch noch die das zweite Isolationsgebiet 430 geöffnet. Dies geschieht vorzugsweise durch eine Kombination von trocken- und nasschemischer Ätzung. Die Trockenätzung trägt auf anisotrope Weise den Großteil des Materials ab. Dann wird die Oberfläche des Siliziums des Kollektors 420 durch nasschemische Ätzung freigelegt. Die nasschemische Ätzung ist hierzu vorzuziehen, da sie aufgrund hoher Selektivität und dem Ausschluss von Strahlenschädigungen die Siliziumoberfläche bei der Freilegung besonders schont.

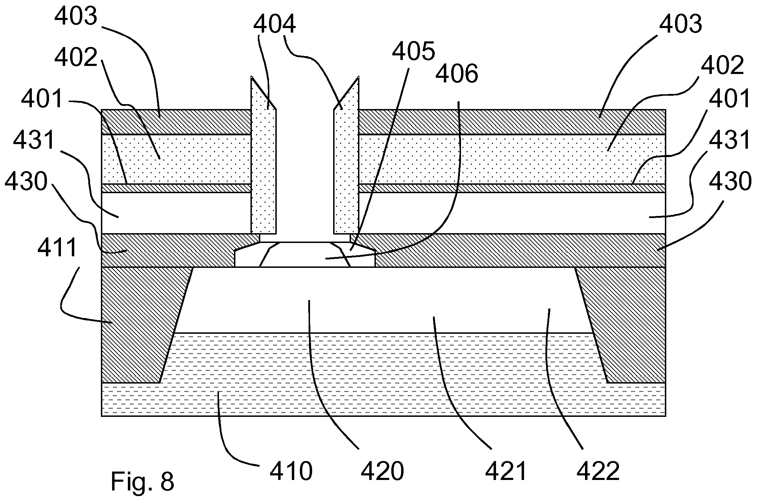

Es besteht die Möglichkeit, die zu öffnende Schicht 430 aus einem Schichtstapel bestehend aus zwei Schichten herzustellen, wobei die Kombination von Schicht-Materialien und Ätzmittel so gewählt werden, dass eine untere der zwei Schichten beim verwendeten nasschemischen Ätzprozess eine größere Ätzrate als eine obere der zwei Schichten aufweist. In diesem Fall kommt beim isotropen nasschemischen Ätzen ein Profil zustande, wie es in Fig.8 angedeutet ist. Bei diesem Profil wird die Öffnung in der Schicht 430 nach unten, also in einer Richtung zum Substratinneren hin, breiter. Dieses Profil kann Vorteile für den fertigen Transistor bezüglich eines geringeren Kollektorwiderstandes bei kleiner Kollektor-Basis-Kapazität haben.

An dieser Stelle ist zu beachten, dass die Hilfsschicht 403 von der Ätzung der Schicht 430 ebenfalls betroffen ist und der Schichtabtrag bei der Einstellung der Ausgangsschichtdicke berücksichtigt werden muss.

Als nächster Schritt wird auf der freigelegten Siliziumoberfläche des Kollektors in dem Bereich der Transistorfensteröffnung eine einkristalline Halbleiterschicht 405 durch selektives epitaktisches Wachstum erzeugt. Diese Schicht ist 5 nm bis 200 nm, vorzugsweise 60 nm bis 150 nm dick. Selektives Wachstum bedeutet, dass auf den Materialien, aus denen die Spacer 404 und die Hilfsschicht 403 bestehen, keine Materialabscheidung stattfindet.

Durch Ionenimplantation wird ein innerer Bereich 406 der Schicht 405 mit n-Dotierung versehen. In Fig.8 ist eine Momentaufnahme an diesem Punkt der Fertigung dargestellt. Ein an den n-dotierten inneren Bereich angrenzender äußerer Bereich wird zur Erzielung von Kapazitätsvorteilen vorzugsweise schwach n-dotiert oder schwach p-dotiert. Dies erfolgt typischerweise gleich bei Abscheidung der Schicht 405.

In einem nasschemischen Ätzprozess werden nun die Spacer 404 teilweise von der zur Innenseite des Fensters zeigenden Seitenwand der Halbleiterschicht 431 entfernt. In einem unteren Bereich der Halbleiterschicht 431 werden die Spacer in diesem Schritt vollständig entfernt. Um dies zu ermöglichen, kann beispielsweise die Dicke der gewachsenen Schicht 405 so gewählt oder ihre Oberfläche nachträglich so zurückgezogen werden, dass die Spacer in einem Ätzprozess auch von unten her angegriffen werden.

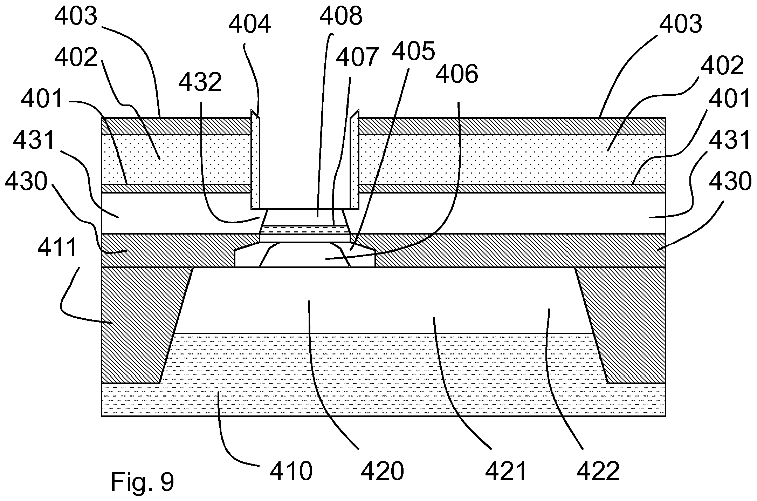

In einer darauf folgenden selektiven epitaktischen Abscheidung des Basisschichtstapels 407 und der Deckschicht 408 wird somit gleichzeitig ein polykristallines inneres Basisanschlussgebiet 432 geschaffen, das die Verbindung des äußeren Basisanschlussgebietes 431 mit der Basis 407b herstellt. Das Herstellungsstadium nach dem epitaktischen Abscheidungsprozess ist in Fig. 9 dargestellt.

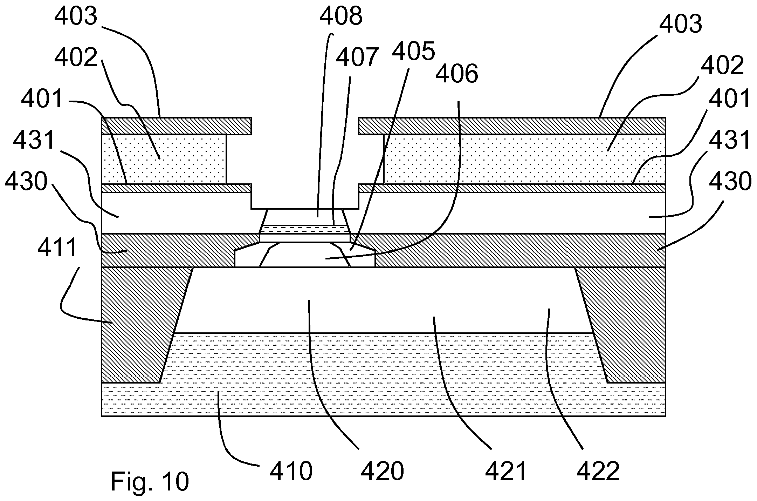

In einem nun folgenden nasschemischen Ätzprozess werden die Spacer 404 vollständig entfernt und weiterhin die Hilfsschicht 402 lateral abgetragen, so dass eine Aushöhlung zwischen den Schichten 401 und 403 entsteht. Die Tiefe dieser Aushöhlung in lateraler Richtung, die durch die zeitliche Dauer des Ätzprozesses eingestellt werden kann, bestimmt die spätere Überlappung des Emitterkontaktes 460 mit dem Basisanschlussgebiet 431. Die Überlappung ist somit selbstjustiert zu den übrigen im Transistorfenster erzeugten Bereichen des Bipolartransistors positioniert. Der Moment nach der nasschemischen Ätzung ist in Fig. 10 dargestellt.

Es werden nun im inneren des Transistorfensters nochmals Spacer, bestehend aus einer ersten Spacer-Schicht 450 und einer zweiten Spacer-Schicht 409, durch Schichtabscheidung und nachfolgende, größtenteils anisotrope Ätzung erzeugt. Der letzte Schritt der Ätzung, der die Oberfläche der Deck-(engl. Cap-) Schicht 408 freilegt, wird vorzugsweise durch eine nasschemische Ätzung bewerkstelligt, um die Oberfläche der Cap-Schicht 408 zu schonen.

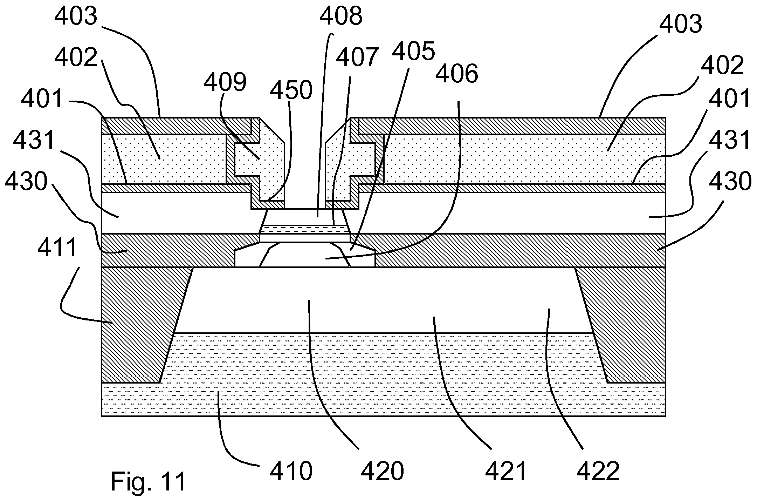

Das Material der zweiten Spacer-Schicht 409 sollte so gewählt werden, dass sie später selektiv zur ersten Spacer-Schicht 450 in einem isotropen Ätzprozess entfernt werden kann. Die zweite Spacer-Schicht 409 stellt eine Hilfsschicht dar, die die L-förmige Gestalt der ersten Spacer-Schicht 450 erzeugt, die für die Funktion des Bipolartransistors vorteilhaft ist. Die erste Spacer-Schicht 450 besteht vorzugsweise aus SiO₂ und ist 20 nm bis 80 nm, vorzugsweise 50nm bis 70nm dick. Die zweite Spacer-Schicht 409 besteht vorzugsweise aus Si₃N₄ und ist 50 nm bis 130 nm, vorzugsweise 70 nm bis 110 nm dick. Der Moment nach der nasschemischen Freilegung der Oberfläche der Cap-Schicht 408 ist in Fig. 11 dargestellt.

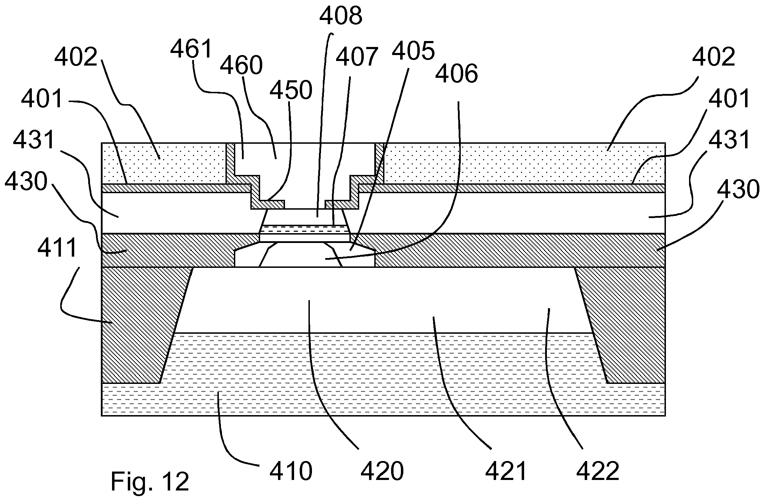

Die zweite Spacer-Schicht 409 wird nun durch einen nasschemischen Ätzprozess entfernt. Dann wird eine n-dotierte Halbleiterschicht abgeschieden, die den späteren Emitter 460 bildet. Die Abscheidung kann dabei entweder als selektive Abscheidung einer einkristallinen Schicht, als Abscheidung einer polykristallinen Schicht, als differentielle Abscheidung, die auf der Deckschicht 408 einkristallines und auf allen anderen Gebieten polykristallines Material erzeugt, oder als differentielle Abscheidung, die auf der Deckschicht 408 einkristallines und auf allen anderen Gebieten amorphes Material erzeugt, ausgeführt werden. Im Falle der rein polykristallinen oder einer differentiellen Abscheidung wird unmittelbar nach der Abscheidung das Material, das außerhalb des Transistorfensters auf der Hilfsschicht 403 abgeschieden wurde, durch einen chemisch-mechanischen Polierprozess (CMP) abgetragen. Durch den CMP-Schritt und nachfolgende Ätzschritte zur Reinigung der Waferoberfläche wird auch die Hilfsschicht 403 entfernt. Dieser Moment der Fertigung ist in Fig. 12 gezeigt.

Zur Fertigstellung des Transistors bis zu dem in Fig.5 dargestellten Zustand sind nun noch folgende Schritte notwendig.

Zunächst wird mit Hilfe einer photolithographisch erzeugten Lackmaske die Hilfsschicht 401, die Isolationsschicht 401 und das Basisanschlussgebiet 431 so strukturiert, dass das Basisanschlussgebiet seine endgültige Form erhält. Die Strukturierung erfolgt durch übliche Trockenätzprozesse.

In einem weiteren Schritt wird die Hilfsschicht 402 in einem nasschemischen Ätzprozess selektiv zu den freiliegenden SiO₂- und Si-Schichten entfernt.

Dann wird schließlich die Isolationsschicht 401 von der Oberfläche des Basisanschlussgebietes und die Isolationsschicht 430 von der Oberfläche des Kolektorkontaktgebietes 422 in einem vorzugsweise anisotropen Trockenätzprozess entfernt, der das SiO₂ möglichst selektiv gegenüber den freiliegenden Siliziumbereichen, beispielsweise dem des Emitters, entfernt.

Im weiteren Verlauf wird der Bipolartransistor durch die Erzeugung einer hohen n-Dotierung (nicht dargestellt) im Bereich des Kolektorkontaktgebietes 422, vorzugsweise durch Ionenimplantation, die Erzeugung eines Silizides (nicht dargestellt) zur Verringerung parasitärer Widerstandsanteile auf den Emitter-, Basis- und Kollektorkontaktgebieten (nicht dargestellt), und schließlich der Erzeugung einer Kontaktierung durch Metallkontakte (nicht dargestellt) fertiggestellt, die den Bipolartransistor mit einem von ihm durch eine Isolationsschicht getrennten Leitbahnsystem verbinden.

### 2. Beispiel

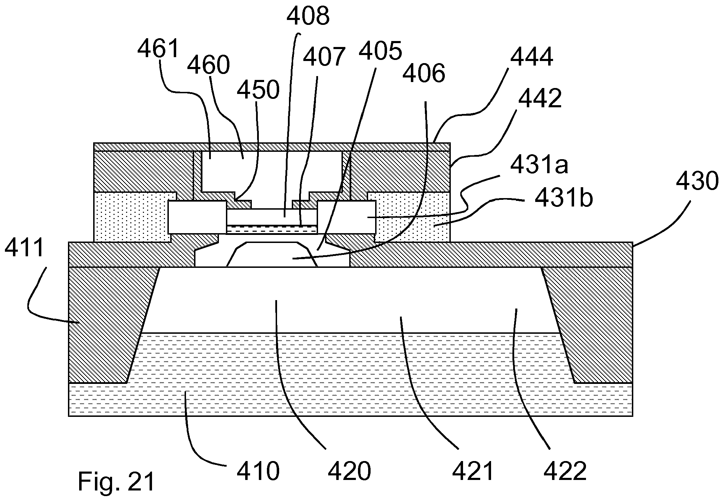

Ein Ausführungsbeispiel einer erfindungsgemäßen Halbleitervorrichtung mit einem vertikalen Bipolartransistor, bei dem die Überlappung von Emitterkontakt und Basisanschlussgebiet in selbstjustierter Weise hergestellt ist und das Basisanschlussgebiet ganz oder teilweise einkristallin, bestehend aus einem anderen Material als im inneren Transistor verwendet, ausgeführt werden kann, wird nun unter Bezugnahme auf Fig. 13 und Fig. 21 erläutert. Fig.13 zeigt eine Querschnittsansicht dieses zweiten Ausführungsbeispiels. Fig. 21 zeigt eine Variante des zweiten Ausführungsbeispiels. Es werden in den Figuren 13 bis 21, die sich auf die beiden Varianten des 2. Beispiels beziehen, für gleiche Strukturelemente dieselben Bezugszeichen wie im 1. Beispiel der Fig. 5 bis 12 verwendet.

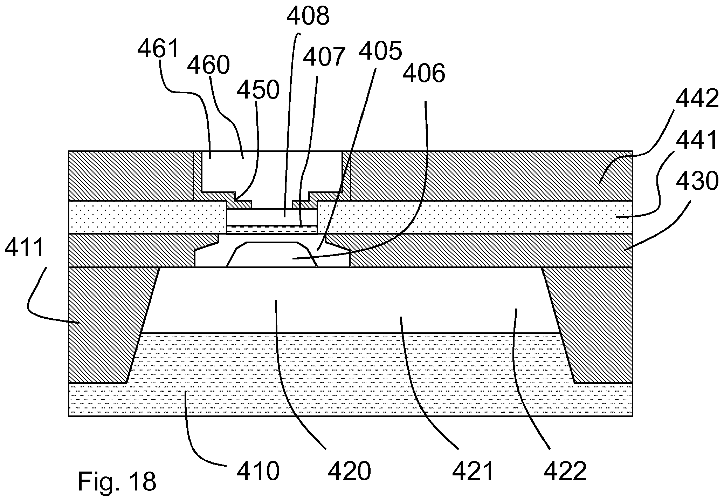

Der Aufbau des vertikalen Bipolartransistors des vorliegenden zweiten Ausführungsbeispiels ist in beiden Varianten in Vielem identisch mit dem des ersten Ausführungsbeispiels, mit Ausnahme folgender Strukturmerkmale:
- es fehlt der innere polykristalline Teil des Basisanschlussgebietes, der im Ausführungsbeispiel der Fig. 5 mit dem Bezugszeichen 432 gekennzeichnet ist. Das Basisanschlussgebiet 431 schließt im Ausführungsbeispiel der Fig. 13 unmittelbar an den Basisschichtstapel 407 an.
- das Basisanschlussgebiet 431 ist einkristallin.
- In der Variante des Beispiels der Fig. 18 ist das Basisanschlussgebiet jedoch nur teilweise einkristallin. Ein erster Bereich 431a, der lateral unmittelbar an den Basisstapel 407 anschließt, ist einkristallin und ein zweiter Bereich 431b, der wiederum an den Bereich 431a lateral anschließt, ist polykristallin. Der einkristalline Bereich kann durch epitaktisches Wachstum oder durch amorphes Abscheiden mit nachfolgender thermischer Behandlung erzeugt werden.
- Das Basisanschlussgebiet kann in der Variante der Fig. 21 derart gestaltet sein, dass der zweite Bereich 431 b eine größere Dicke als der Bereich 431a aufweist, was den elektrischen Widerstand vorteilhaft verringert.
- Das Basisanschlussgebiet, insbesondere der einkristalline Bereich, kann aus einem anderen Material, als es in der Halbleiterschicht 405, im Basisstapel 407 oder der Deckschicht 408 verwendet wird, hergestellt werden. Dies verschafft im Gegensatz zu bekannten Ausführungsformen nach dem Stand der Technik einen Vorteil bei der Wahl eines in Bezug auf die elektrische Funktion des Transistors geeigneten Materials.

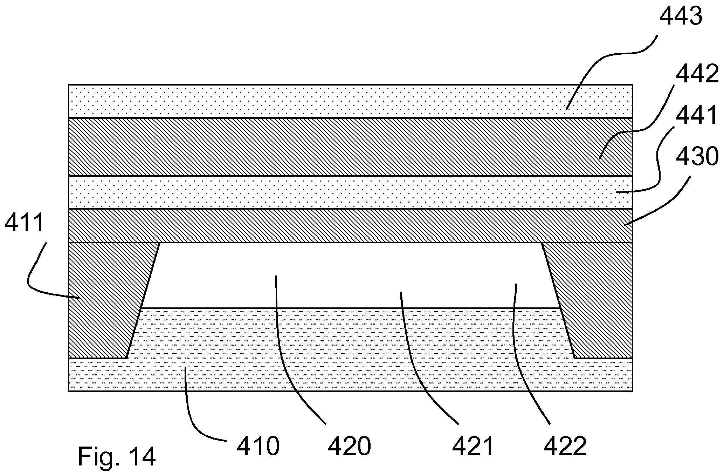

Es wird nun mit Bezug auf die Figuren 14 bis 20 ein Verfahren zur Herstellung der erfindungsgemäßen Halbleitervorrichtung wie oben in diesem Beispiel beschrieben erläutert.

Grundlage für die Herstellung bildet ein Substrat 410 (Fig.14), das vorzugsweise ein möglichst hochohmiges, einkristallines p-leitendes (geringe p-leitende Dotierung) Silizium umfasst. Der Bearbeitungsprozess des Substrates 410 beginnt mit der Erzeugung der Feldisolationsgebiete 411. Im vorliegenden Beispiel werden als Feldisolationsgebiete sogenannte "Shallow Trenches" eingesetzt. Zwischen den Feldisolationsgebieten entstandene Inseln von Si-Gebieten bilden aktive Gebiete. Das aktive Gebiet wird nach Fertigstellung des vertikalen Bipolartransistors den Kollektor 420, das Kollektoranschlussgebiet 421 und Kollektorkontaktgebiet 422 aufnehmen.

Die Dotierung des Kollektors 420 wird nach Fertigstellung der Feldisolationsgebiete durch Ionenimplantation in das Silizium eingebracht.

Fig. 14 zeigt eine Momentaufnahme während der Fertigung des Bipolartransistors. Feldisolationsgebiete 411 und der untere Höhenabschnitt 420 des Kollektors sind bereits hergestellt. Des Weiteren ist ein Schichtstapel, bestehend aus der Isolationsschicht 430, einer ersten Hilfsschicht 441, einer zweiten Hilfsschicht 442 und einer dritten Hilfsschicht 443, erzeugt worden. Die Isolationsschicht 401 besteht vorzugsweise aus SiO₂ und ist 20nm bis 150nm, vorzugsweise 80nm bis 120nm dick. Die erste Hilfsschicht 441 besteht vorzugsweise aus Si₃N₄ und ist 20nm bis 150nm, vorzugsweise 50nm bis 120nm dick. Die zweite Hilfsschicht 442 besteht vorzugsweise aus SiO₂ und ist 50nm bis 250nm, vorzugsweise 130nm bis 170nm dick. Die dritte Hilfsschicht 443 besteht vorzugsweise aus Si₃N₄ und ist 50nm bis 100nm, vorzugsweise 60nm bis 80nm dick.

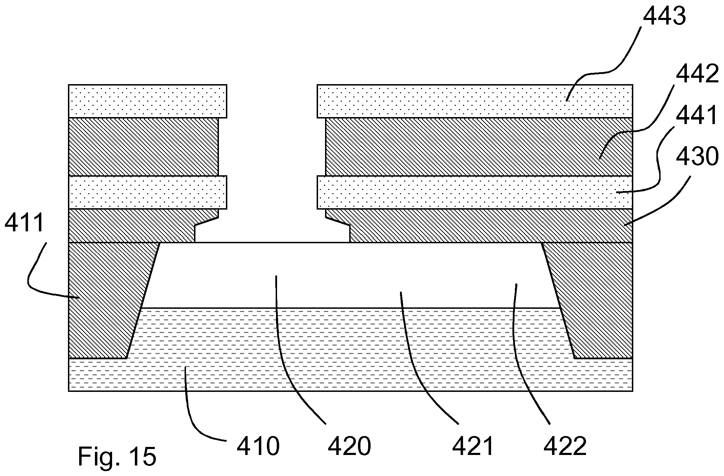

Es wird nun ein durch einen photolithographischen Prozess definiertes Fenster in den Schichten 443, 442, 441 und 430 erzeugt, vgl. Fig. 15. Dabei werden vorzugsweise übliche anisotrope Trockenätzverfahren eingesetzt, bis auf die Entfernung der untersten Bereiche der Schicht 430, die mit einem nasschemischen Ätzverfahren möglichst schonend vom einkristallinen Bereich 420, dem unteren, ersten Höhenabschnitt des Kollektors entfernt werden. Hierbei kann analog zu Beispiel 1 das Profil so eingestellt werden, das das Transistorfenster zum Substrat hin breiter wird.

An dieser Stelle können optional die Hilfsschichten 441 und 443, falls sie nach der nasschemischen Ätzung deutlich weiter in das Transistorfenster hineinragen als die Schichten 430 und 442, durch einen weiteren nasschemischen Ätzprozess zurückgezogen werden.

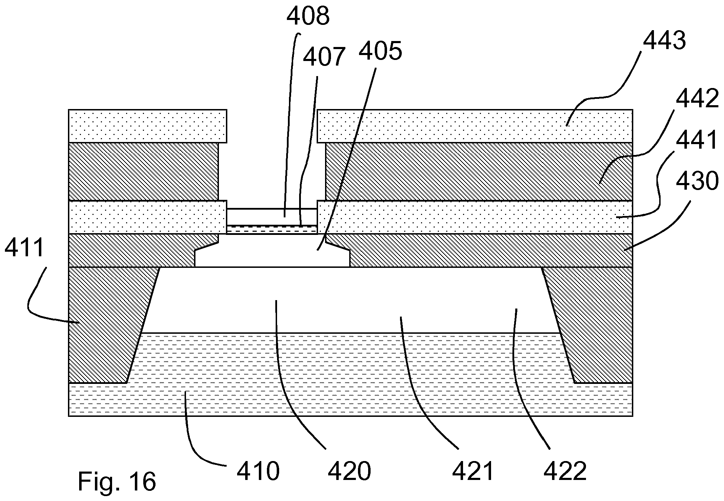

Nun werden die einkristalline Halbleiterschicht 405, der Basisstapel 407 und die Deckschicht 408 durch selektives epitaktisches Wachstum im Bereich des Transistorfensters auf dem ersten Höhenabschnitt 420 des Kollektors erzeugt, vgl. Fig. 16. Das Wachstum kann zwischenzeitlich zur Implantation des SIC-Gebiets 406 unterbrochen werden. Es ist jedoch auch eine spätere Implantation durch den gewachsenen Basisstapel hindurch möglich. Das SIC-Gebiet 406 ist im vorliegenden Ausführungsbeispiel erst im späteren Verfahrensstadium der Fig. 18 eingezeichnet, ohne damit jedoch die Variante einer früheren Implantation wie beschrieben auszuschließen.

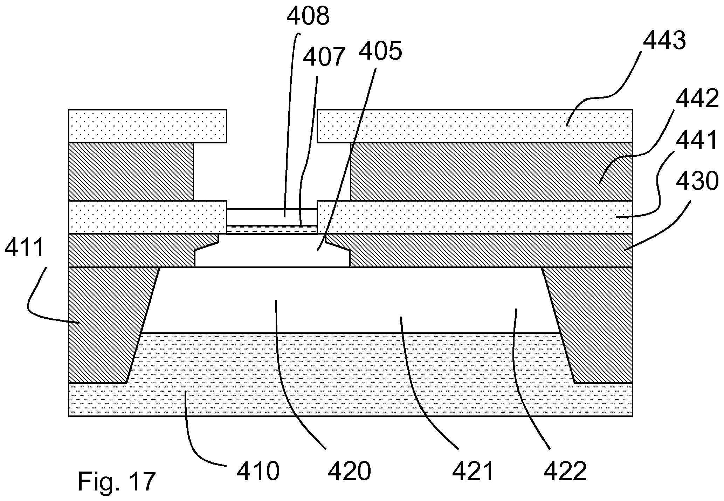

An dieser Stelle wird dann durch einen nasschemischen Ätzprozess die Hilfsschicht 442 lateral zurückgezogen, so dass zwischen den Schichten 441 und 443 eine Aushöhlung entsteht, vgl. Fig. 17. Die Ausdehnung dieser Aushöhlung in lateraler Richtung, die für eine gegebene Ätzlösung durch die zeitliche Dauer des Ätzprozesses eingestellt werden kann, bestimmt die spätere laterale Ausdehnung der Überlappung des Emitterkontaktes 460 mit dem Basisanschlussgebiet 431. Die laterale Ausdehnung dieser Überlappung ist somit selbstjustiert zum Transistorfenster und somit auch zu den übrigen im Transistorfenster erzeugten Bereichen des Bipolartransistors positioniert.

Nun werden die L-förmigen Spacer 450 und der Emitter 460 analog zu Beispiel 1 erzeugt, indem zunächst ein Spacer bestehend aus einer SiO₂- und einer Si₃N₄ Schicht an der Innenwand des Transistorfensters erzeugt werden, das Si₃N₄ entfernt wird und der Emitter 460 polykristallin, einkristallin oder teils einkristallin und teils polykristallin erzeugt wird, entweder durch selektives Wachstum oder durch eine Kombination von polykristalliner Abscheidung oder differentieller Abscheidung mit einem CMP-Schritt. Die Hilfsschicht 443 wird dann entfernt. Dieser Moment der Fertigung ist in Fig. 15 dargestellt.

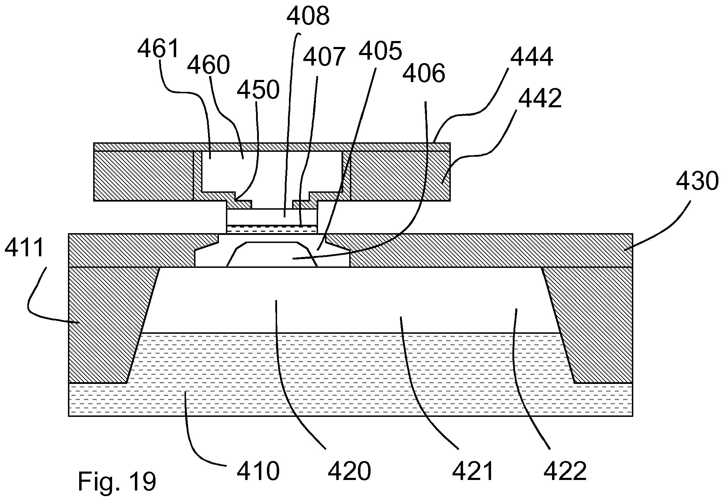

Es folgt die Abscheidung einer Hilfsschicht 444, vorzugsweise bestehend aus SiO₂ und 30 nm bis 100 nm, vorzugsweise 40 nm bis 60 nm dick. Mit Hilfe einer photolithographisch strukturierten Lackmaske werden die Schichten 444 und 442 durch übliche Trockenätzverfahren strukturiert, so dass sie die Form des späteren Basisanschlussgebietes vorgeben. Vorzugsweise durch ein nasschemisches Ätzverfahren wird nun die Hilfsschicht 441 selektiv zu allen übrigen vorhandenen Schichten lateral soweit unter der Schicht 442 entfernt, dass die Seitenwand des Basisschichtstapels 407 freiliegt. Dieser Zustand ist in Fig. 19 dargestellt.

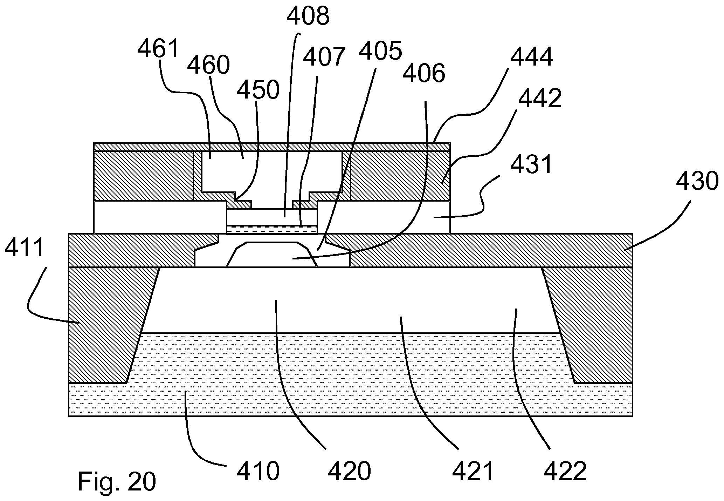

Nun wird das Basisanschlussgebiet 431 erzeugt. Dies geschieht vorzugsweise durch selektives epitaktisches Wachstum. Es kann aber auch durch Abscheidung einer amorphen Schicht, die durch thermische Behandlung kristallin gemacht wird, hergestellt werden. Dieser Zustand der Fertigung ist in Fig. 20 dargestellt.

Eine weitere Variante der Gestaltung des Basisanschlussgebietes ist in Fig. 21 dargestellt. Nach der Erzeugung eines ersten, einkristallinen Bereiches 431a des Basisanschlussgebietes kann der Abstand zwischen den Schichten 430 und 442 durch eine isotrope Ätzung vergrößert werden, bevor ein weiterer Bereich 431b, einkristallin oder polykristallin sein kann, erzeugt wird.

Falls das Basisanschlussgebiet nicht ausschließlich durch selektive Verfahren hergestellt wurde, wird in einem nächsten Schritt das Silizium, das außerhalb des eigentlichen Basisanschlussgebietes entstanden ist, durch einen Trockenätzprozess entfernt, der das Silizium selektiv gegenüber SiO₂ entfernt. Damit bleibt das Basisanschlussgebiet während dieser Ätzung durch die Schicht 442 geschützt, die als Maske für die Ätzung dient.

Durch einen folgenden Ätzprozess, der SiO₂ selektiv zu Silizium entfernt, werden die SiO₂-Schichten, die das Emitter-, Basis- und Kollektorkontaktgebiet abdecken, entfernt. Durch diesen Prozess gelangt man zu einem Querschnitt, wie er in Fig. 13 dargestellt ist.

Endgültig fertiggestellt wird der Bipolartransistor durch die Erzeugung einer hohen n-Dotierung im Bereich des Kollektorkontaktes 422, vorzugsweise durch Ionenimplantation, die Erzeugung eines Silizides zur Verringerung parasitärer Widerstandsanteile auf den Emitter-, Basis- und Kollektorkontaktgebieten, und schließlich der Erzeugung einer Kontaktierung durch Metallkontakte, die den Bipolartransistor mit einem von ihm durch eine Isolationsschicht getrennten Leitbahnsystem verbinden.

Selbstverständlich sind weitere Varianten zu den beschriebenen Verfahrensführungen möglich. In einer Variante sind beispielsweise die Strukturen gegenüber einer herkömmlichen Abscheidung um 45 Grad um eine senkrecht zur Substratoberfläche stehende Achse gedreht, wodurch Vorteile beim selektiven Wachstum von Si erzielt werden, was letztendlich auch die Hochgeschwindigkeitseigenschaften des Bipolartransistors verbessert.

Die Halbleitervorrichtung kann neben Bipolartransistoren auch andere, in einer MOS- oder CMOS-Technologie gefertigte Halbleiter-Bauelemente enthalten. Die vorstehende Beschreibung der Figuren beschränkte sich auf das Beispiel von npn-Bipolartransistoren. Die Erfindung ist hierauf jedoch nicht beschränkt. Ein Bipolartransistor einer erfindungsgemäßen Halbleitervorrichtung kann entweder als npn- oder als pnp-Transistor ausgeführt sein. Bei der Materialwahl für den inneren Transistor und das Basisanschlussgebiets kann der Fachmann auf die in Standardwerken veröffentlichten Materialparameter der Elektronen- und Löcherbeweglichkeiten in Frage kommender Halbleitermaterialien zurückgreifen.

## Patentansprüche

1. Halbleitervorrichtung,
umfassend eine Substratschicht (410) aus einem Halbleitermaterial eines ersten Leitfähigkeitstyps mit einem ersten Isolationsgebiet (411), und eine Vielzahl vertikaler Bipolartransistoren, wobei die vertikalen Bipolartransistoren jeweils umfassen:
- einen in einer Öffnung des ersten Isotationsgebietes (411) angeordneten ersten Höhenabschnitt eines Kollektors (420) aus einkristallinem Halbleitermaterial eines zweiten Leitfähigkeitstyps,
- ein zweites Isolationsgebiet (430), das teils auf dem ersten Höhenabschnitt des Kollektors (420) und teils auf dem ersten Isolationsgebiet (411) aufliegt und im Bereich des Kollektors eine Öffnung besitzt, in der ein zweiter Höhenabschnitt (405) des Kollektors aus einkristallinem Material angeordnet ist, der einen inneren Bereich (406) des zweiten Leitfähigkeitstyps umfasst,
- eine Basis (407b) aus einkristallinem Halbleitermaterial des ersten Leitfähigkeitstyps,
- ein Basisanschlussgebiet (431) auf dem zweiten Isolationsgebiet (430), das in lateraler Richtung die Basis (407b) umgibt und das, abgesehen von einer Ankeimschicht oder einer Metallisierungsschicht, auf dem zweiten Isolationsgebiet (430) entweder teilweise oder vollständig einkristallin ist,
- einen T-förmigen Emitter (460) aus Halbleitermaterial des zweiten Leitfähigkeitstyps, der das Basisanschlussgebiet (431) überlappt, wobei
- ein horizontaler Balken des T-förmigen Emitters nach außen hin mit dem jeweiligen Basisanschlussgebiet überlappt, und wobei
- die laterale Ausdehnung dieser Überlappung über die Gesamtzahl der Bipolartransistoren der Halbleitervorrichtung eine Variation von maximal 10 Nanometer aufweist.

2. Halbleitervorrichtung nach Anspruch 1, bei der das Material des Basisanschlussgebiets Siliziumgermanium mit einem Germaniumanteil von mehr als 35% ist.

3. Halbleitervorrichtung nach Anspruch 1 oder 2, bei der das Material des Basisanschlussgebiets Germanium ist, während das Material von Kollektor, Basis und Emitter Silizium oder Siliziumgermanium ist.

4. Halbleitervorrichtung nach Anspruch 1, bei der das Basisanschlussgebiet zwei Teilgebiete (431a, 431b) enthält, von denen ein unmittelbar an die Basis (407b) angrenzendes erstes Teilgebiet (431a) einkristallin ist.

5. Halbleitervorrichtung nach Anspruch 4, bei der ein zweites Teilgebiet (431b) des Basisanschlussgebietes eine größere vertikale Dicke als das erste Teilgebiet (432a) aufweist.

6. Verfahren zur Herstellung einer Vielzahl von vertikalen Bipolartransistoren einer Halbleitervorrichtung, bei dem, für jeden Bipolartransistor,
- in einem Schichtstapel, der teils auf einem ersten Höhenabschnitt eines Kollektors (420), welcher aus einkristallinem Halbleitermaterial besteht, und teils auf einem diesen umgebenden Isolatorgebiet (411) abgeschieden ist, ein Fenster im lateralen Bereich des Kollektors hergestellt wird,
- im Fenster ein zweiter Höhenabschnitt (405) des Kollektors und ein Basisstapel (407) einkristallin abgeschieden werden,
- ein seitlich an den Basisstapel anschließendes Basisanschlussgebiet (431) hergestellt wird, das auf einer Isolationsschicht des Schichtstapels, die teilweise auf dem Isolationsgebiet (411) und teilweise auf dem Kollektor (420) aufliegt und ein zweites Isolationsgebiet (430) bildet abgesehen von einer Ankeimschicht oder Metallisierungsschicht entweder teilweise oder vollständig einkristallin hergestellt wird,
- in mindestens einer über dem Basisstapel liegenden Schicht des Schichtstapels eine sich seitlich über das Fenster hinaus erstreckende seitliche Aushöhlung hergestellt wird, und bei dem
- ein T-förmiger Emitter unter Ausfüllen der seitlichen Aushöhlung hergestellt wird, wobei eine laterale Ausdehnung des horizontalen T-Balkens und seine laterale Überlappung mit dem Basisanschlussgebiet durch die seitliche Aushöhlung in selbstjustierter Herstellungsweise vorgegeben wird, wobei die laterale Ausdehnung dieser Überlappung über die Gesamtzahl der Bipolartransistoren der Halbleitervorrichtung eine Variation von maximal 10 Nanometer aufweist.

7. Verfahren nach Anspruch 6, bei dem das Basisanschlussgebiet aus Siliziumgermanium mit einem Germaniumanteil von mindestens 35% oder aus Germanium hergestellt wird.

8. Verfahren nach einem der Ansprüche 6 oder 7, bei dem der Schichtstapel, in Richtung des Schichtwachstums, entweder die folgende Schichtkombination enthaltend oder aus der folgenden Schichtkombination bestehend hergestellt wird: das zweite Isolationsgebiet (430), eine erste Hilfsschicht (441), eine zweite Hilfsschicht (442) und eine dritte Hilfsschicht (443).

9. Verfahren nach Anspruch 8, bei dem das Ausbilden des Fensters (400a) im Schichtstapel (430, 441, 442, 443), so durchgeführt wird, dass das Fenster sich im lateralen Bereich des Kollektorgebiets (420) in Tiefenrichtung bis zu dessen erstem Höhenabschnitt erstreckt.

10. Verfahren nach einem der Ansprüche 8 oder 9, weiter umfassend ein selektiv epitaktisches Abscheiden eines zweiten Höhenabschnitts (405) des Kollektors im Bereich des Fensters, eines Basisstapels (407), bestehend aus einer Pufferschicht (407a) und der Basisschicht (407b) sowie einer Deckschicht (408), so dass der Basisschichtstapel in Wachstumsrichtung maximal bis zur Unterseite der zweiten Hilfsschicht (442) reicht.

11. Verfahren nach Anspruch 10, weiter umfassend ein selektives, seitliches Zurückätzen der zweiten Hilfsschicht (442) im Bereich des Fensters (400a), so dass eine sich seitlich über das Fenster hinaus erstreckende seitliche Aushöhlung der zweiten Hilfsschicht entsteht.

12. Verfahren nach einem der Ansprüche 8 bis 11, weiter umfassend:
- Abscheiden des T-förmigen Emitters (460) im Fenster (400a) und in der Aushöhlung der zweiten Hilfsschicht, wobei die Weite der über die laterale Ausdehnung des Fensters (400) hinausragenden lateralen Überlappung des Emitters (460) mit dem Basisanschlussgebiet (431) durch die Weite der Zurückatzung sich in selbstjustierter Weise ergibt.

13. Verfahren nach einem der Ansprüche 8 bis 12, mit den weiteren Schritten
- Entfernen der dritten Hilfsschicht (443) und Abdecken des Emitters mit einer vierten Hilfsschicht (444),
- Strukturierung der zweiten (442) und vierten Hilfsschicht (444), so dass sie nur noch im Gebiet des gewünschten Basisanschlussgebietes vorhanden sind,
- Zurückätzen der ersten Hilfsschicht (441) unterhalb der zweiten Hilfsschicht (442), so weit, dass die Seitenwand der Basis (407b) freiliegt, und
- Erzeugen des Basisanschlussgebietes durch selektives epitaktisches Wachstum.

14. Verfahren nach einem der Ansprüche 9 bis 13, bei dem zunächst nur ein Teil des Basisanschlussgebietes selektiv epitaktisch gewachsen wird, danach der vertikale Abstand der Isolationsschicht (430) und der zweiten Hilfsschicht (442) durch isotropes Ätzen vergrößert wird und dann der übrige Teil des Basisanschlussgebietes durch selektive oder differentielle Epitaxie erzeugt wird

## Claims

1. Semiconductor device,
comprising a substrate layer (410) made of a semiconductor material of a first conductivity type with a first insulating region (411), and a plurality of vertical bipolar transistors, wherein the vertical bipolar transistors each comprise:
- a first height section of a collector (420) made of monocrystalline semiconductor material of a second conductivity type, said section being arranged in an opening of the first insulating region (411),
- a second insulating region (430) which rests partly on the first height section of the collector (420) and partly on the first insulating region (411) and which in the region of the collector has an opening in which a second height section (405) of the collector made of monocrystalline material is arranged, comprising an inner region (406) of the second conductivity type,
- a base (407b) made of monocrystalline semiconductor material of the first conductivity type,
- a base connection region (431) on the second insulating region (430) which surrounds the base (407b) in the lateral direction and which, apart from a seed layer or a metallisation layer, is either partially or completely monocrystalline on the second insulating region (430),
- a T-shaped emitter (460) made of semiconductor material of the second conductivity type, which overlaps the base connection region (431), wherein
- a horizontal bar of the T-shaped emitter overlaps outwards with the respective base connection region, and wherein
- the lateral extent of this overlap over the total number of bipolar transistors of the semiconductor device has a variation of a maximum of 10 nanometres.

2. Semiconductor device according to claim 1, in which the material of the base connection region is silicon germanium with a germanium content of more than 35%.

3. Semiconductor device according to claim 1 or 2, in which the material of the base connection region is germanium, while the material of the collector, base and emitter is silicon or silicon germanium.

4. Semiconductor device according to claim 1, in which the base connection region contains two subregions (431a, 431b), of which a first subregion (431a) directly adjoining the base (407b) is monocrystalline.

5. Semiconductor device according to claim 4, in which a second subregion (431b) of the base connection region has a greater vertical thickness than the first subregion (432a).

6. Method for manufacturing a plurality of vertical bipolar transistors of a semiconductor device, in which, for each bipolar transistor,
- a window is produced in the lateral region of a collector (420) in a layer stack which is partly deposited on a first height section of the collector, which consists of monocrystalline semiconductor material, and partly on an insulating region (411) surrounding it,
- a second height section (405) of the collector and a base stack (407) are deposited in monocrystalline form in the window,
- a base connection region (431) laterally adjoining the base stack is produced which, apart from a seed layer or metallisation layer is produced either partially or completely monocrystalline from an insulating layer of the layer stack, which rests partly on the insulating region (411) and partly on the collector (420) and forms a second insulating region (430),
- a lateral cavity extending laterally beyond the window is produced in at least one layer of the layer stack lying above the base stack,
and in which
- a T-shaped emitter is produced by filling the lateral cavity, wherein a lateral extent of the horizontal T-bar and its lateral overlap with the base connection region are predetermined by the lateral cavity in a self-adjusted production method, wherein the lateral extent of this overlap over the total number of bipolar transistors of the semiconductor device has a variation of a maximum of 10 nanometres.

7. Method according to claim 6, in which the base connection region is produced from silicon germanium with a germanium content of at least 35% or from germanium.

8. Method according to any one of claims 6 or 7, in which the layer stack is produced either containing the following layer combination or consisting of the following layer combination, in the direction of layer growth: the second insulating region (430), a first auxiliary layer (441), a second auxiliary layer (442) and a third auxiliary layer (443).

9. Method according to claim 8, in which the formation of the window (400a) in the layer stack (430, 441, 442, 443) is carried out in such a way that the window extends in the lateral region of the collector region (420) in the depth direction up to its first height section.

10. Method according to any one of claims 8 or 9, further comprising a selective epitaxial deposit of a second height section (405) of the collector in the region of the window, of a base stack (407), consisting of a buffer layer (407a) and the base layer (407b) and a cover layer (408), so that the base layer stack extends in the growth direction at most to the bottom of the second auxiliary layer (442).

11. Method according to claim 10, further comprising a selective, lateral etching back of the second auxiliary layer (442) in the region of the window (400a), so that a lateral cavity of the second auxiliary layer that extends laterally beyond the window is produced.

12. Method according to any one of claims 8 to 11, further comprising:
- depositing the T-shaped emitter (460) in the window (400a) and in the cavity of the second auxiliary layer, wherein the width of the lateral overlap of the emitter (460) with the base connection region (431) protruding beyond the lateral extent of the window (400) results from the width of the etching back in a self-adjusted manner.

13. Method according to any one of claims 8 to 12, with the further steps
- removing the third auxiliary layer (443) and covering the emitter with a fourth auxiliary layer (444),
- structuring the second (442) and fourth auxiliary layers (444) so that they are only present in the region of the desired base connection region,
- etching back the first auxiliary layer (441) below the second auxiliary layer (442) so far that the side wall of the base (407b) is exposed, and
- generating the base connection region by selective epitaxial growth.

14. Method according to any one of claims 9 to 13, in which initially only part of the base connection region is selectively grown epitaxially, then the vertical distance between the insulating layer (430) and the second auxiliary layer (442) is increased by isotropic etching and then the remaining part of the base connection region is generated by selective or differential epitaxy.

## Revendications

1. Dispositif semi-conducteur
comprenant une couche de substrat (410) constituée d'un matériau semi-conducteur d'un premier type de conductivité avec une première zone d'isolation (411), et une pluralité de transistors bipolaires verticaux, dans lequel les transistors bipolaires verticaux comprennent chacun :
- une première portion en hauteur, disposée dans une ouverture de la première zone d'isolation (411), d'un collecteur (420), constituée d'un matériau semi-conducteur monocristallin d'un deuxième type de conductivité,
- une deuxième zone d'isolation (430) qui repose en partie sur la première portion en hauteur du collecteur (420) et en partie sur la première zone d'isolation (411), et présente, au niveau du collecteur, une ouverture dans laquelle est disposée une deuxième portion en hauteur (405) du collecteur constituée d'un matériau monocristallin, qui comprend une partie interne (406) du deuxième type de conductivité,
- une base (407b) constituée d'un matériau semi-conducteur monocristallin du premier type de conductivité,
- une zone de raccordement de base (431) sur la deuxième zone d'isolation (430), qui entoure la base (407b) dans la direction latérale et qui, excepté une couche de germination ou une couche de métallisation, sur la deuxième zone d'isolation (430), est soit partiellement soit entièrement monocristalline,
- un émetteur en forme de T (460) constitué d'un matériau semi-conducteur du deuxième type de conductivité, qui se superpose à al zone de raccordement de la base (431), dans lequel
- une barre horizontale de l'émetteur en forme de T se superpose vers l'extérieur avec la zone de raccordement de la base respective et dans lequel
- l'extension latérale de cette superposition présente, sur le nombre total de transistors bipolaires du dispositif semi-conducteur, une variation de 10 nanomètres maximum.

2. Dispositif semi-conducteur selon la revendication 1, dans lequel le matériau de la zone de raccordement de la base est du silicium-germanium avec une part de germanium supérieure à 35 %.

3. Dispositif semi-conducteur selon la revendication 1 ou 2, dans lequel le matériau de la zone de raccordement de la base est du germanium tandis que le matériau du collecteur, de la base et de l'émetteur est du silicium ou du silicium-germanium.

4. Dispositif semi-conducteur selon la revendication 1, dans lequel la zone de raccordement de la base contient deux zones partielles (431a, 431b) dont une zone partielle (421a), directement adjacente à la base (407b), est monocristalline.

5. Dispositif semi-conducteur selon la revendication 4, dans lequel une deuxième zone partielle (431b) de la zone de raccordement de la base présente une épaisseur verticale supérieure à la première zone partielle (432a).

6. Procédé de fabrication d'une pluralité de transistor bipolaires verticaux d'un dispositif semi-conducteur, dans lequel, pour chaque transistor bipolaire,
- dans un empilement de couches, qui est déposé en partie sur une première portion en hauteur d'un collecteur (420), qui est constituée d'un matériau monocristallin, et en partie sur une zone d'isolation (411) entourant celle-ci, est réalisée une fenêtre dans la partie latérale du collecteur,
- dans la fenêtre, sont déposés une deuxième portion en hauteur (405) du collecteur et un empilement de couches (407) de manière monocristalline,
- une zone de raccordement de la base (431), se raccordant latéralement à l'empilement de base, est réalisée, qui est réalisée de manière soit partiellement soit entièrement monocristalline, sur une couche d'isolation de l'empilement de couches, qui repose en partie sur la zone d'isolation (411) et en partie sur le collecteur (420) et qui constitue une deuxième zone d'isolation (430), excepté une couche de germination ou une couche de métallisation,
- dans au moins une couche de l'empilement de couches, se trouvant au-dessus de l'empilement de base, est réalisée une cavité latérale s'étendant au-delà de la fenêtre et dans lequel
- un émetteur en forme de T est réalisé en remplissant la cavité latérale, dans lequel une extension latérale de la barre horizontale du T et sa superposition latérale avec la zone de raccordement de la base est prédéfinie par la cavité latérale dans un mode de fabrication auto-aligné, dans lequel l'extension latérale de cette superposition présente, sur le nombre total de transistors bipolaires du dispositif semi-conducteur, une variation de 10 nanomètres maximum.

7. Procédé selon la revendication 6, dans lequel la zone de raccordement de la base est constituée de silicium-germanium avec une part de germanium d'au moins 35 % ou est constituée de germanium.

8. Procédé selon l'une des revendications 6 ou 7, dans lequel l'empilement de couches est réalisé, en direction de la croissance des couches, de façon à contenir la combinaison de couches suivantes ou à être constitué de la combinaison de couches suivante : la deuxième zone d'isolation (430), une première couche auxiliaire (441), une deuxième couche auxiliaire (442) et une troisième couche auxiliaire (443).

9. Procédé selon la revendication 8, dans lequel la formation de la fenêtre (400a) est réalisée dans l'empilement de couches (430, 441, 442, 443) de façon à ce que la fenêtre s'étende dans la partie latérale de la zone de collecteur (420) dans la direction de la profondeur jusqu'à sa première portion en hauteur.

10. Procédé selon l'une des revendications 8 ou 9, comprenant en outre un dépôt sélectivement épitaxial d'une deuxième portion en hauteur (405) du collecteur au niveau de la fenêtre, d'un empilement de couches (407), constitué d'une couche tampon (407a) et de la couche de base (407b) ainsi que d'une couche de recouvrement (408), de façon à ce que l'empilement de couches de base arrive, dans la direction de croissance, au maximum jusqu'à la face inférieure de la deuxième couche auxiliaire (442).

11. Procédé selon la revendication 10, comprenant en outre une gravure en retrait latérale sélective de la deuxième couche auxiliaire (442) au niveau de la fenêtre (400a) de façon à obtenir une cavité latérale de la deuxième couche auxiliaire s'étendant latéralement au-delà de la fenêtre.

12. Procédé selon l'une des revendications 8 à 11, comprenant en outre :
- le dépôt de l'émetteur en forme de T (460) dans la fenêtre (400a) et dans la cavité de la deuxième couche auxiliaire, dans lequel l'étendue latérale de la superposition de l'émetteur (460) avec la zone de raccordement de la base (431), dépassant de l'extension latérale de la fenêtre (400), résulte de l'étendue de la gravure en retrait de manière auto-alignée.

13. Procédé selon l'une des revendications 8 à 12, avec les étapes supplémentaires suivantes
- élimination de la troisième couche auxiliaire (443) et recouvrement de l'émetteur avec une quatrième couche auxiliaire (444),
- structuration des deuxième (442) et quatrième (444) couches auxiliaires de façon à ce qu'elles soient présentes dans la zone de la zone de raccordement base souhaitée,
- gravure en retrait de la première couche auxiliaire (441) en dessous de la deuxième couche auxiliaire (442) de façon à ce que la paroi latérale de la base (407b) soit dégagée et
- réalisation de la zone de raccordement de la base par croissance épitaxiale sélective.

14. Procédé selon l'une des revendications 9 à 13, dans lequel, d'abord seule une partie de la zone de raccordement de la base croît de façon sélectivement épitaxiale, puis la distance verticale entre la couche d'isolation (430) et la deuxième couche auxiliaire (442) est agrandie par gravure isotrope puis la partie restante de la zone de raccordement de la base est produite par épitaxie sélective ou différentielle.
